(19) Europäisches Patentamt / European Patent Office / Office européen des brevets

(11) **EP 3 657 190 A1**

(12) **EUROPEAN PATENT APPLICATION**
published in accordance with Art. 153(4) EPC

(43) Date of publication:
**27.05.2020 Bulletin 2020/22**

(51) Int Cl.:
*G01R 31/36* (2020.01)    *H01M 10/42* (2006.01)
*H01M 10/48* (2006.01)    *H02J 7/00* (2006.01)

(21) Application number: 18835384.1

(22) Date of filing: **29.06.2018**

(86) International application number:
**PCT/JP2018/024811**

(87) International publication number:
**WO 2019/017183 (24.01.2019 Gazette 2019/04)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.07.2017 JP 2017140256**
**14.06.2018 JP 2018113985**

(71) Applicant: **GS Yuasa International Ltd.**
**Kyoto-shi, Kyoto 601-8520 (JP)**

(72) Inventors:
• **UKUMORI, Nan**
**Kyoto-shi**
**Kyoto 601-8520 (JP)**
• **INOUE, Katsuya**
**Kyoto-shi**
**Kyoto 601-8520 (JP)**
• **IKEDA, Yuichi**
**Kyoto-shi**
**Kyoto 601-8520 (JP)**
• **KIDO, Ryota**
**Kyoto-shi**
**Kyoto 601-8520 (JP)**

(74) Representative: **Grünecker Patent- und Rechtsanwälte**
**PartG mbB**
**Leopoldstraße 4**
**80802 München (DE)**

(54) **ESTIMATION DEVICE, POWER STORAGE DEVICE, ESTIMATION METHOD, AND COMPUTER PROGRAM**

(57) An energy storage device 3 has a single electrode containing an active material in which repeated charge-discharge changes a first characteristic that is an energy storage amount-potential charge characteristic, and a second characteristic that is an energy storage amount-potential discharge characteristic. An estimation device 6 includes: a storage unit 63 that stores a plurality of first characteristics, second characteristics, or pieces of V-dQ/dV of the single electrode in accordance with a change in a feature value, which is changed by repeated charge-discharge, or stores as a function of the feature value; an acquisition unit 62 that acquires the feature value of the energy storage device 3; and a first estimation unit 62 that refers to the first characteristic, the second characteristic, or the V-dQ/dV, or refers to the function on the basis of the feature value acquired by the acquisition unit 62, to estimate the first characteristic, the second characteristic, or the V-dQ/dV of the single electrode.

Fig. 8

**Description**

TECHNICAL FIELD

The present invention relates to an estimation device, an energy storage apparatus including the estimation device, an estimation method, and a computer program.

BACKGROUND ART

For vehicle secondary batteries used in electric vehicles, hybrid vehicles, and the like, and industrial secondary batteries used in power storing apparatuses, solar power generating systems, and the like, a higher capacity is required. Various studies and improvements have been made so far, and it is difficult to realize a higher capacity by only improving an electrode structure and the like. Therefore, development of positive electrode materials having a higher capacity than current materials is underway.

Conventionally, lithium transition metal composite oxide with $\alpha$-NaFeO$_2$ type crystal structure has been studied as a positive active material for a nonaqueous electrolyte secondary battery such as a lithium ion secondary battery, and a nonaqueous electrolyte secondary battery using LiCoO$_2$ has been widely put into practical use. A discharge capacity of LiCoO$_2$ has been about 120 to 130 mAh/g.

When the lithium transition metal composite oxide is represented by LiMeO$_2$ (Me is a transition metal), it has been desired to use Mn as Me. In a case where Mn is contained as Me, a structure changes to a spinel type at a time of charge when a molar ratio of Mn in Me, Mn/Me, exceeds 0.5, and the crystal structure cannot be maintained. Therefore, charge-discharge cycle performance is extremely inferior.

Various LiMeO$_2$ type active materials in which the molar ratio of Mn in Me, Mn/Me, is 0.5 or smaller while a molar ratio of Li to Me, Li/Me, is approximately 1, have been proposed and put to practical use. A positive active material containing LiNi$_{1/2}$Mn$_{1/2}$O$_2$, LiNi$_{1/3}$Co$_{1/3}$Mn$_{1/3}$O$_2$, and the like, which are lithium transition metal composite oxides, has a discharge capacity of 150 to 180 mAh/g.

With respect to the LiMeO$_2$ type active material, there is also known a so-called lithium-rich active material that contains lithium transition metal composite oxide in which the molar ratio of Mn in Me, Mn/Me, exceeds 0.5 while a composition ratio of Li to a ratio of transition metal (Me), Li/Me, is greater than 1.

As the above-described high-capacity positive electrode material, a lithium-rich Li$_2$MnO$_3$-based active material has been studied. This material has a property called hysteresis that causes, for an identical state of charge (SOC), differences in voltage and electrochemical characteristics between individual SOC-open circuit voltage (OCV) at a time of charge and discharge.

In a case of having hysteresis, since the voltage is not uniquely determined with respect to SOC, it is difficult to estimate the SOC by an OCV method that estimates SOC on the basis of SOC-OCV. Since the SOC-OCV curve is not uniquely determined, it is also difficult to predict dischargeable energy at a certain point.

The lithium-rich material has a property called voltage fade in which an SOC-open circuit potential (OCP) curve of a positive electrode is changed over substantially the entire region by repeated charge-discharge. Since a value of an average discharge potential decreases, it is necessary to estimate not only a dischargeable capacity but also dischargeable watt-hour as a state of health (SOH) at the present moment. Even if the most recent charge-discharge history is identical, the SOC-OCV curve shape of a battery cell (hereinafter also simply referred to as "cell") based on a SOC-OCP curve of a single electrode changes significantly due to deterioration. Therefore, the OCV method cannot be adopted. Examples of the condition in which the most recent charge-discharge history is identical include, for example, charge after passing through a fully discharged state. In charge after passing through the fully discharged state, the SOC-OCP curve of the single electrode changes in accordance with deterioration. Therefore, the SOC-OCV curve shape of the cell changes significantly.

In a case where SOC is estimated by a current integration method that integrates a charge-discharge current of a secondary battery, a measurement error of a current sensor accumulates when current integration is continued for a long period of time. Further, the battery capacity decreases with time. Therefore, an estimation error of the SOC estimated by the current integration method increases with time. Conventionally, when current integration is continued for a long period of time, the SOC is estimated by the OCV method, and OCV reset is performed to reset error accumulation.

Also in an energy storage device using an electrode material having voltage fade and hysteresis, an error accumulates when current integration is continued. However, since the voltage is not uniquely determined with respect to SOC, it is difficult to estimate the SOC by the OCV method (to perform the OCV reset).

In controlling such an energy storage device containing an active material, it is necessary to estimate SOC-OCP characteristics of the positive electrode from a fully charged state to a fully discharged state and from a fully discharged state to a fully charged state, at the present moment.

Current techniques for estimating SOH and SOC of nonaqueous electrolyte secondary batteries are difficult to apply to energy storage devices using the active material having VF and hysteresis properties.

An energy storage device such as a lithium ion secondary battery is often used repeatedly in a state where the SOC is 40% or more, in a vehicle or the like. When charging, a voltage is often increased to near full charge. After charging, when the voltage is high, that is, when a deterioration state can be grasped in a high voltage region (high SOC region) where SOC is high, a dischargeable capacity and dischargeable watt-hour can be estimated, and control for suppressing deterioration can be performed at an appropriate timing. Therefore, the convenience is high.

Also in the high SOC region, it is required to estimate the deterioration state simply, quickly, and highly accurately.

A determination unit of a device of evaluating a storage battery disclosed in Patent Document 1 determines a charging/discharging tendency of the storage battery on the basis of measurement data including voltage data of the storage battery. A correction unit correct the voltage data on the basis of a correction parameter according to the charging/discharging tendency and/or a deterioration state of the storage battery. A QV curve generation unit generates a QV curve of the storage battery on the basis of the voltage data. An evaluation unit evaluates the deterioration state on the basis of the QV curve.

PRIOR ART DOCUMENT

PATENT DOCUMENT

Patent Document 1: JP-A-2016-85166

SUMMARY OF THE INVENTION

PROBLEMS TO BE SOLVED BY THE INVENTION

The device of evaluating a storage battery of Patent Document 1 requires complicated steps in order to evaluate the storage battery. The voltage data is acquired, and the voltage data is corrected by removing a voltage component resulting from an internal resistance. In an active material of Patent Document 1, SOC-OCP of a single electrode is not changed over substantially the entire region by repeated charge-discharge. In a case of an active material that causes voltage fade, the device and method of evaluating the storage battery of Patent Document 1 cannot be employed.

An object of the present invention is to provide an estimation device that can be applied to an energy storage device having a single electrode in which energy storage amount-potential characteristics are changed by repeated charge-discharge, and that estimates the energy storage amount characteristics and the like, an energy storage apparatus including the estimation device, an estimation method, and a computer program.

Here, the energy storage amount means a charge rate such as SOC, an energy dischargeable amount, and the like.

MEANS FOR SOLVING THE PROBLEMS

An estimation device according to one aspect of the present invention estimates at least one of a first characteristic, a second characteristic, and V-dQ/dV that is a relationship between a potential V and dQ/dV, of a single electrode of an energy storage device having the single electrode containing an active material in which repeated charge-discharge changes the first characteristic that is an energy storage amount-potential charge characteristic, and the second characteristic that is an energy storage amount-potential discharge characteristic. The estimation device includes: a storage unit that stores a plurality of at least any of first characteristics, second characteristics, or pieces of V-dQ/dV of the single electrode in accordance with a change in a feature value, which is changed by repeated charge-discharge, or stores as a function of the feature value; an acquisition unit that acquires the feature value of the energy storage device; and a first estimation unit that refers to at least one of the first characteristic, the second characteristic, or the V-dQ/dV, or refers to the function on the basis of the feature value acquired by the acquisition unit, to estimate at least one of the first characteristic, the second characteristic, and the V-dQ/dV of the single electrode.

ADVANTAGES OF THE INVENTION

According to the above configuration, on the basis of the feature value, it is possible to satisfactorily estimate energy storage amount characteristics of the energy storage device having the single electrode containing the active material in which the first characteristic and the second characteristic are changed by repeated charge-discharge.

BRIEF DESCRIPTION OF THE DRAWINGS

Fig. 1 is a graph showing an example of SOC-OCP of a positive electrode.

Fig. 2 is a conceptual view showing a relationship between a potential range of a single electrode corresponding to a predetermined voltage range and a range of an amount of charge corresponding to each deterioration state in each potential range.

Fig. 3A is a graph showing a relationship between dQ/dV and a potential of a positive electrode of an initial product containing an active material in which a first characteristic and a second characteristic are changed by repeated charge-discharge, while Fig. 3B is a graph showing a relationship between dQ/dV and a potential of a positive electrode of a deteriorated product.

Fig. 4 is a graph showing transition of K absorption edge energy of Ni of the active material calculated by X-ray absorption spectroscopy measurement (XAFS measurement) with respect to a charge potential.

Fig. 5 is a perspective view showing an example of an energy storage apparatus.

Fig. 6 is a perspective view showing another example of the energy storage apparatus.

Fig. 7 is an exploded perspective view of a battery module.

Fig. 8 is a block diagram of the battery module.

Fig. 9 is a flowchart showing a procedure of an energy storage amount characteristics estimation process by a CPU.

Fig. 10 is a graph showing a result of obtaining an error of calculated SOC-OCP data with respect to SOC-OCP data based on actual measured values.

Fig. 11 is a graph showing a result of obtaining an error of calculated SOC-OCP data with respect to SOC-OCP data based on actual measured values.

Fig. 12 is a graph showing a result of obtaining an error of calculated SOC-OCP data with respect to SOC-OCP data based on actual measured values.

Fig. 13 is a graph showing a result of obtaining an error of calculated SOC-OCP data with respect to SOC-OCP data based on actual measured values.

Fig. 14 is a graph showing a result of obtaining an error of calculated SOC-OCP data with respect to SOC-OCP data based on actual measured values.

Fig. 15 is a graph showing a result of obtaining an error of calculated SOC-OCP data with respect to SOC-OCP data based on actual measured values.

Fig. 16 is a graph showing a result of obtaining an error of calculated SOC-OCP data with respect to SOC-OCP data based on actual measured values.

Fig. 17 is a graph showing a result of obtaining an error of calculated SOC-OCP data with respect to SOC-OCP data based on actual measured values.

Fig. 18 is a graph showing a result of obtaining an error of calculated SOC-OCP data with respect to SOC-OCP data based on actual measured values.

Fig. 19 is a graph showing a result of obtaining an error of calculated SOC-OCP data with respect to SOC-OCP data based on actual measured values.

Fig. 20 is a graph showing a result of obtaining an error of calculated SOC-OCP data with respect to SOC-OCP data based on actual measured values.

Fig. 21 is a flowchart showing a procedure of an SOC estimation process by the CPU.

Fig. 22 is a flowchart showing a procedure of the SOC estimation process by the CPU.

Fig. 23 is a flowchart showing a procedure of a deterioration state estimation process by a CPU 62.

Fig. 24 is a graph showing a result of obtaining V-dQ/dV at a time of charge, in correspondence with a plurality of cycles.

Fig. 25 is a graph showing a result of obtaining V-dQ/dV at a time of discharge, in correspondence with a plurality of cycles.

Fig. 26 is a graph showing a result of obtaining a relationship between a number of battery cycles and dQ/dV at 4.55 V at a time of charge.

Fig. 27 is a graph showing a result of obtaining a relationship between a number of battery cycles and a time period $\Delta t$ in which a voltage at a time of charge reaches 4.55 V from 4.50 V.

Fig. 28 is a graph showing a number of battery cycles and a result of obtaining a gradient [$\Delta$(dQ/dV)/$\Delta$V] of a V-dQ/dV curve between voltages 4.50 V and 4.55 V at a time of charge.

Fig. 29 is a graph showing a number of battery cycles and a result of obtaining |dQ/dV| at 4.45 V at a time of discharge.

Fig. 30 is a graph showing a result of obtaining a relationship between a number of battery cycles and a time period $\Delta t$ in which a voltage at a time of discharge reaches 4.40 V from 4.45 V.

Fig. 31 is a graph showing a number of battery cycles and a result of obtaining a gradient [$\Delta$(dQ/dV)/$\Delta$V] of a V-dQ/dV curve between 4.45 V and 4.40 V at a time of discharge.

MODE FOR CARRYING OUT THE INVENTION

Hereinafter, the present invention will be specifically described with reference to the drawings showing embodiments thereof.

[Summary of Embodiments]

An estimation device according to an embodiment estimates at least one of a first characteristic, a second characteristic, and V-dQ/dV that is a relationship between a potential V and dQ/dV, of a single electrode of an energy storage device having the single electrode containing an active material in which repeated charge-discharge changes the first characteristic that is an energy storage amount-potential charge characteristic, and the second characteristic that is an energy storage amount-potential discharge characteristic. The estimation device includes: a storage unit that stores a plurality of at least any of first characteristics, second characteristics, or pieces of V-dQ/dV of the single electrode in accordance with a change in a feature value, which is changed by repeated charge-discharge, or stores as a function of the feature value; an acquisition unit that acquires the feature value of the energy storage device; and a first estimation unit that refers to at least one of the first characteristic, the second characteristic, or the V-dQ/dV, or refers to the function on the basis of the feature value acquired by the acquisition unit, to estimate at least one of the first characteristic, the second characteristic, and the V-dQ/dV of the single electrode.

Here, dQ/dV is a differential value obtained by differentiating an amount of charge or a discharge capacity Q by a potential V.

According to the above configuration, a plurality of first characteristics, second characteristics, or pieces of V-dQ/dV corresponding to the feature value are stored in accordance with deterioration of the energy storage device. When the feature value at the present moment is acquired, the stored first characteristics, second characteristics, or pieces of V-dQ/dV are referred to, and a first characteristic, a second characteristic, or dQ/dV-V at the present moment is estimated. Alternatively, data regarding the first characteristic, the second characteristic, or V-dQ/dV is stored as a function of the feature value, and the first characteristic, the second characteristic, or dQ/dV-V is calculated by substituting the feature value at the present moment.

In a case of using an active material having a voltage fade property in which energy storage amount-potential characteristics of the single electrode are changed by repeated charge-discharge, the current energy storage amount-potential characteristics of the single electrode or V-dQ/dV can be easily and highly accurately obtained with use of the feature value.

The current first characteristic, second characteristic, or V-dQ/dV of the single electrode is to be an index indicating a deterioration state at the present moment. Therefore, even in a complicated use environment, it is possible to highly accurately monitor a deterioration state of the single electrode.

In the estimation device described above, the feature value may be at least one of an amount of charge or a discharge capacity in a predetermined voltage range, or an average discharge potential.

A voltage range of a cell corresponding to a potential range in which there is a linear relationship between the amount of charge or the discharge capacity and the average discharge potential, and a potential difference (cell voltage) from a counter electrode does not change before and after deterioration, is set as the predetermined voltage range. In a case of using the amount of charge or the discharge capacity in the predetermined voltage range as the feature value, and storing a plurality of first characteristics, second characteristics, or pieces of V-dQ/dV in association with a feature value corresponding to a deterioration degree, a first characteristic, a second characteristic, or V-dQ/dV at the present moment can be accurately estimated. Similarly, also in a case of using the average discharge potential, the first characteristic, the second characteristic, or V-dQ/dV can be accurately estimated.

In the estimation device described above, in accordance with magnitude of the amount of charge or the discharge capacity, or the average discharge potential, the storage unit may store a plurality of pieces of V-dQ/dV or store the function, and the first estimation unit may refer to a relationship between the feature value and the V-dQ/dV to estimate V-dQ/dV of the single electrode.

By storing the plurality of pieces of V-dQ/dV or the function in accordance with magnitude of the feature value, and referring to the relationship between the feature value and V-dQ/dV, V-dQ/dV of the single electrode can be accurately estimated.

In the estimation device described above, the amount of charge or the discharge capacity may be corrected in accordance with a deterioration degree of the active material.

Since the amount of charge or the discharge capacity changes with deterioration, the energy storage amount-potential characteristics or V-dQ/dV can be more accurately estimated by correcting in accordance with the deterioration degree.

In the estimation device described above, the feature value may be any one of, within a high voltage range, dQ/dV at a predetermined voltage, a time period for reaching a second voltage from a first voltage, and a gradient

(Δ(dQ/dV)/ΔV) of V-dQ/dV between a first voltage and a second voltage.

The dQ/dV, the time period, and the [Δ(dQ/dV)/ΔV] change in correspondence with a change in V-dQ/dV due to repeated charge-discharge. Therefore, in a case of storing a plurality of first characteristics, second characteristics, or pieces of V-dQ/dV in association with the feature value, a first characteristic, a second characteristic, or V-dQ/dV at the present moment can be accurately estimated.

An estimation device according to an embodiment estimates a deterioration state of an energy storage device having a single electrode containing an active material in which repeated charge-discharge changes a first characteristic that is an energy storage amount-potential charge characteristic, and a second characteristic that is an energy storage amount-potential discharge characteristic. The estimation device includes: an acquisition unit that acquires a feature value that is any one of, within a high voltage range, dQ/dV at a predetermined voltage, a time period for reaching a second voltage from a first voltage, and a gradient [Δ(dQ/dV)/ΔV] of V-dQ/dV between a first voltage and a second voltage; and an estimation unit that estimates a deterioration state of the energy storage device on the basis of the feature value.

When an active material having voltage fade is used, reaction proceeds also in a high voltage range due to a compound caused by deterioration. Therefore, dQ/dV increases with deterioration.

Since the above-described reaction occurs in the high voltage range, a time period Δt for reaching the second voltage from the first voltage in the high voltage range becomes long.

[Δ(dQ/dV)/ΔV] also changes in accordance with deterioration.

dQ/dV, Δt, or Δ(dQ/dV)/ΔV is acquired as the feature value, and a deterioration state of the energy storage device can be satisfactorily estimated with use of this feature value.

In the estimation device described above, the estimation unit may estimate a deterioration state of the energy storage device on the basis of a threshold of the feature value.

The deterioration state of the energy storage device can be easily estimated with the threshold.

In the estimation device described above, the active material may exhibit hysteresis between a first characteristic and a second characteristic, and there may be provided a second estimation unit that estimates a third characteristic that is an energy storage amount-voltage charge characteristic for reference and/or a fourth characteristic that is an energy storage amount-voltage discharge characteristic for reference in estimating an energy storage amount with a voltage of the energy storage device, on the basis of the first characteristic and/or the second characteristic estimated by the first estimation unit, and on the basis of a charge-discharge history of the energy storage device.

When the active material has hysteresis, the third characteristic and/or the fourth characteristic can be accurately estimated on the basis of the first characteristic and/or the second characteristic according to a deterioration state of the single electrode at the present moment and on the basis of the charge-discharge history of the energy storage device.

The estimation device described above may further include a third estimation unit that estimates an energy storage amount on the basis of a charge-discharge history, the third characteristic and/or the fourth characteristic, and an acquired voltage.

In the above configuration, it is possible to easily and satisfactorily estimate an energy storage amount of the energy storage device having an active material that has the voltage fade property and exhibits hysteresis in the energy storage amount-voltage characteristics.

Since the voltage is used, it is possible to estimate a current energy amount stored in the energy storage device, such as watt-hour, as the energy storage amount, without limiting to SOC. On the basis of the charge-discharge characteristics, dischargeable energy up to SOC 0% and charge energy required up to SOC 100% can be predicted. Remaining watt-hour and storable watt-hour at the present moment can be estimated.

Therefore, it is possible to accurately perform: balancing in a case of using a plurality of energy storage devices; control of regenerative acceptance; estimation of a travel distance when the energy storage device is mounted on a vehicle; and the like.

An energy storage apparatus according to the embodiment includes the energy storage device and the estimation device described above.

In the above configuration, the energy storage amount of the energy storage device can be accurately estimated even in a complicated use environment.

An estimation method of an embodiment estimates at least one of a first characteristic, a second characteristic, and V-dQ/dV that is a relationship between a potential V and dQ/dV, of a single electrode of an energy storage device having the single electrode containing an active material in which repeated charge-discharge changes the first characteristic that is an energy storage amount-potential charge characteristic, and the second characteristic that is an energy storage amount-potential discharge characteristic. The estimation method stores a plurality of at least any of first characteristics, second characteristics, or pieces of V-dQ/dV of the single electrode in accordance with a change in a feature value, which is changed by repeated charge-discharge, or has stored as a function of the feature value; and refers to at least one of the first characteristic, the second characteristic, or the V-dQ/dV, or refers to the function on the basis of the acquired feature value, to estimate at least one of the first characteristic, the second characteristic, and the V-dQ/dV of the single electrode.

According to the above configuration, when an active material having the voltage fade property is used, the energy storage amount-potential characteristics or V-dQ/dV of the single electrode can be easily and highly accurately obtained with use of the feature value.

Another estimation method of the embodiment estimates a deterioration state of an energy storage device having a single electrode containing an active material in which repeated charge-discharge changes an energy storage amount-potential charge characteristic and an energy storage amount-potential discharge characteristic. The estimation method: acquires a feature value that is any one of, within a high voltage range, dQ/dV at a predetermined voltage, a time period for reaching a second voltage from a first voltage, and a gradient [$\Delta$(dQ/dV)/$\Delta$V] of V-dQ/dV between a first voltage and a second voltage; and estimates a deterioration state of the energy storage device on the basis of the feature value.

According to the above configuration, dQ/dV, $\Delta$t, or $\Delta$(dQ/dV)/$\Delta$V is acquired as the feature value, and a deterioration state of the energy storage device can be satisfactorily estimated with use of this feature value.

A computer program according to an embodiment causes a computer that estimates at least one of a first characteristic, a second characteristic, and V-dQ/dV that is a relationship between a potential V and dQ/dV, of a single electrode of an energy storage device having the single electrode containing an active material in which repeated charge-discharge changes the first characteristic that is an energy storage amount-potential charge characteristic, and the second characteristic that is an energy storage amount-potential discharge characteristic, to execute processing of: acquiring a feature value that is changed by repeated charge-discharge of the energy storage device; and referring to a table that stores a plurality of at least any of first characteristics, second characteristics, or pieces of V-dQ/dV of the single electrode in accordance with a change in the feature value, or referring to a function stored as the function of the feature value, to estimate at least one of the first characteristic, the second characteristic, and the V-dQ/dV of the single electrode on the basis of the acquired feature value.

Another computer program according to the embodiment causes a computer that estimates a deterioration state of an energy storage device having a single electrode containing an active material in which repeated charge-discharge changes an energy storage amount-potential charge characteristic and an energy storage amount-potential discharge characteristic, to execute processing of: acquiring a feature value that is any one of, within a high voltage range, dQ/dV at a predetermined voltage, a time period for reaching a second voltage from a first voltage, and a gradient ($\Delta$(dQ/dV)/$\Delta$V) of V-dQ/dV between a first voltage and a second voltage; and estimating a deterioration state of the energy storage device on the basis of the feature value.

Hereinafter, an embodiment will be specifically described.

A single electrode of an electrode assembly of the energy storage device according to the embodiment contains an active material having the voltage fade property and having hysteresis in energy storage amount-potential characteristics.

When the active material has the voltage fade property, shapes of an SOC-OCP curve (first characteristic and second characteristic) of the single electrode and of an SOC-OCV curve of a cell are changed by repeated charge-discharge. The cell containing this active material has hysteresis in which a maximum potential difference between the SOC-OCV curves is 100 mV or more in charging from a fully discharged state to a fully charged state and in discharging from a fully charged state to a fully discharged state by applying a minute current.

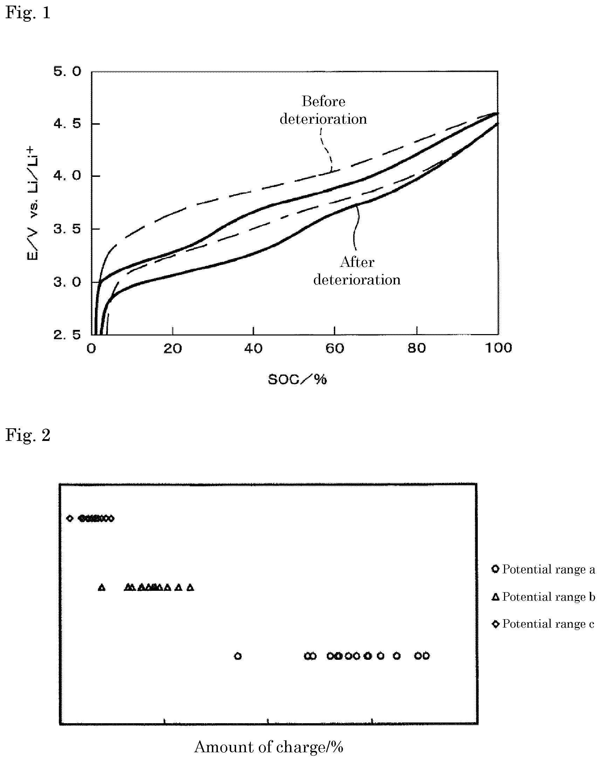

Fig. 1 is a graph showing an example of SOC-OCP of a positive electrode. A horizontal axis represents SOC (%), and a vertical axis represents a potential E as OCP (V vs Li/Li$^+$: Li/Li$^+$ potential based on an equilibrium potential). A charge-discharge curve before deterioration is indicated by a broken line, and a charge-discharge curve after deterioration is indicated by a solid line.

As shown in Fig. 1, voltage fade occurs due to deterioration, and the charge-discharge curve shifts downward.

In a case of an active material having no voltage fade property, the hysteresis does not exist, and the SOC-OCP curve of the single electrode is not changed by repeated charge-discharge. A shape of the SOC-OCV curve of the cell is changed by repeated charge-discharge, due to deterioration (curve reduction) of the single electrode or expansion of a deviation amount of capacity balance.

In the present embodiment, energy storage amount characteristics at the present moment are estimated. Examples of the energy storage amount characteristics include at least any of charge SOC-OCP characteristics, discharge SOC-OCP characteristics, charge V-dQ/dV, or discharge V-dQ/dV, of the single electrode.

There is a correlation between the feature value that is changed by repeated charge-discharge and the above-described energy storage amount characteristics.

In a case of using an amount of charge and a discharge capacity as the feature value, the amount of charge and the discharge capacity may be corrected on the basis of a charge state or positive electrode effectiveness.

An example of a calculation equation for correction of the amount of charge and the discharge capacity is shown.

$$Q(x), dis = n \times Q(x)$$

$$Q(x), cha = n \times (100 + \Delta Qox, max \times Rcha)/100 \times Q(x)$$

Note that $Q(x), dis$: a correction value of a discharge capacity
$Q(x)$: an actual measured value of a discharge capacity
$Q(x), cha$: a correction value of an amount of charge
n: positive electrode effectiveness, $0 \leq n \leq 1$, a value indicating a degree of contraction in an x direction of an SOC-OCP curve
Rcha: a ratio of charge SOC-OCP of a positive electrode

$$Rcha = (\Delta Qox, max - \Delta Qox)/\Delta Qox, max, 0 \leq Rcha \leq 1$$

$$\Delta Qox = \Delta SOCmax - \Delta SOC$$

$\Delta Qox, max$: a maximum value of $\Delta Qox$
$\Delta SOC$: a difference in SOC between discharge SOC-OCP and charge SOC-OCP in a potential at which $Q(x)$ is acquired
$\Delta SOCmax$: a maximum value of $\Delta SOC$

In a case of the active material having the voltage fade property, it is considered that a charge-discharge curve shape changes continuously and uniquely in correspondence with a change (deterioration) in the feature value. Regarding $LiMeO_2$-$Li_2MnO_3$ based active materials, it has been reported that a crystal structure changes with repeated charge-discharge (Journal of Power Sources, vol. 229 (2013), pp 239 to 248). It is considered that the charge-discharge curve shape changes as the crystal structure changes. A result of the article suggests that the crystal structure changes continuously in a charge-discharge cycle at a short-term single temperature level. Further, from a report that the crystal structure has changed from a layered state to a spinel analog crystal, it is inferred that the way of change is one. That is, in a case of an active material having the voltage fade property at a short-term single temperature level, the crystal structure continuously and uniquely changes. From this report, the present inventor has considered that the charge-discharge curve shape changes continuously and uniquely in accordance with a change of the crystal structure, also in a long term and in any use history. From an experimental result to be described later, it has been confirmed that the charge-discharge curve shape changes continuously and uniquely also in a long term and even if the use history is different.

In a case of an active material having no voltage fade property, the charge-discharge curve shape of the single electrode is not changed by repeated charge-discharge. As described above, the charge-discharge curve shape of the cell is changed by repeated charge-discharge individually, that is, non-uniquely, due to deterioration of the single electrode or expansion in a deviation amount of capacity balance.

In the present embodiment, the energy storage amount characteristics of the single electrode continuously and uniquely change with respect to a change in the feature value. Therefore, the energy storage amount characteristics at the present moment can be accurately estimated, by storing a part of change transition of the energy storage amount characteristics with respect to a change in the feature value.

That is, a plurality of at least any of the above-described energy storage amount characteristics are stored in the table in correspondence with a change in the feature value. Alternatively, the energy storage amount characteristics are stored as a function of the feature value.

A CPU 62 described later acquires a feature value at the present moment.

When the feature value is an amount of charge or a discharge capacity, the CPU 62 acquires a feature value in a predetermined voltage range. Note that, when a potential of the counter electrode for each energy storage amount (energy storage amount characteristics of the counter electrode and capacity balance deviation) at the present moment can be estimated, a battery voltage may be converted into a potential of the single electrode, and the converted potential range may be used for feature value extraction.

As the potential range of the single electrode corresponding to the voltage range, it is preferable to select a range in which there is a linear relationship between the amount of charge or the discharge capacity and the average discharge potential of the single electrode, and a potential difference (cell voltage) from the counter electrode does not change before and after deterioration.

Fig. 2 is a conceptual view showing a relationship between a potential range of a positive electrode corresponding to the predetermined voltage range and a range of an amount of charge corresponding to each deterioration state in each potential range. The potential range becomes narrower in the order of a, b, and c. When the potential range is narrowed, the range of the amount of charge is narrowed. That is, an error increases with a decrease of the potential range to be used. Whereas, when the potential range is wide, time and efforts are required to acquire the amount of charge. Therefore, it is preferable to set an appropriate potential range in consideration of balance between estimation accuracy and ease of measurement.

On the basis of the acquired feature value, the CPU 62 refers to the stored energy storage amount characteristics to estimate energy storage amount characteristics at the present moment. Alternatively, the CPU 62 calculates energy storage amount characteristics at the present moment by substituting the acquired feature value into the stored function of the feature value.

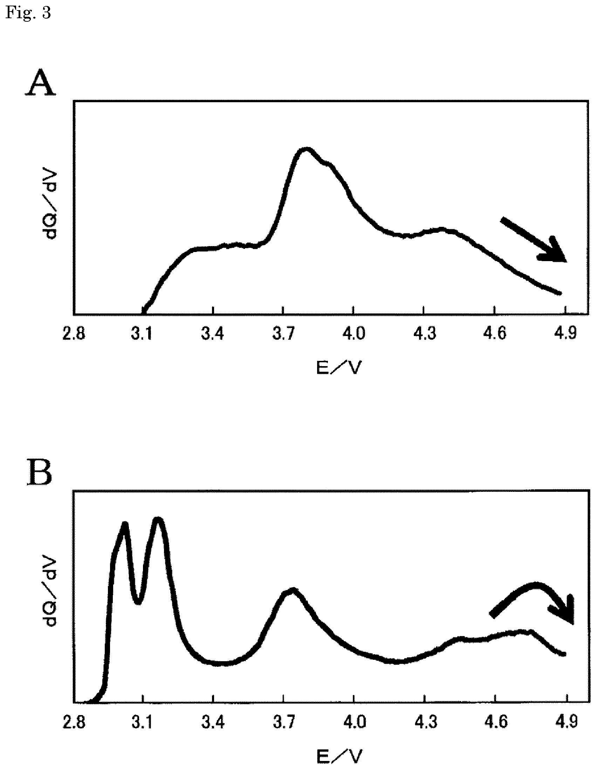

Fig. 3A is a graph showing a relationship between dQ/dV and a potential of a positive electrode of an initial product containing the active material, while Fig. 3B is a graph showing a relationship between dQ/dV and a potential of a positive electrode of a deteriorated product. A horizontal axis represents a potential (V vs $Li/Li^+$: $Li/Li^+$ potential based on equilibrium potential), and a vertical axis represents dQ/dV.

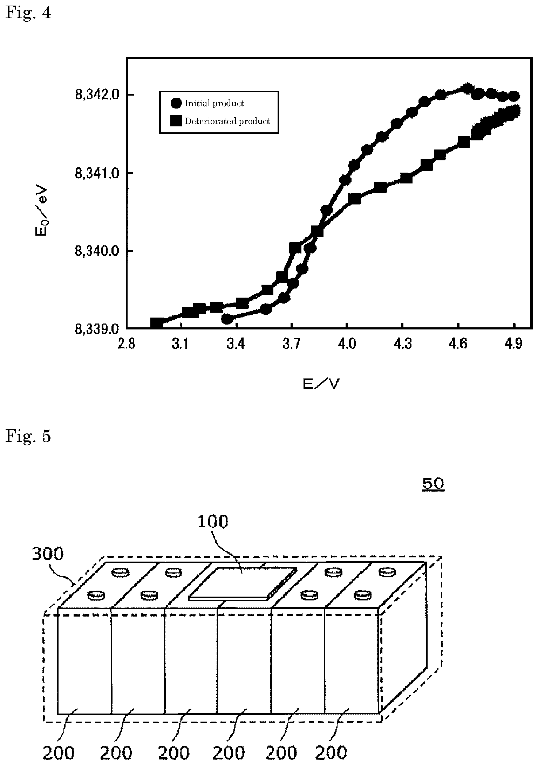

Fig. 4 is a graph showing transition of K absorption edge energy of Ni of the active material calculated by X-ray absorption spectroscopy measurement (XAFS measurement) with respect to a charge potential. A horizontal axis represents a charge potential $E(V$ vs $Li/Li^+)$, and a vertical axis represents K absorption edge energy $E_0(eV)$ of Ni. In Fig. 4, the initial product is indicated by ● and the deteriorated product is indicated **by ■.**

In Fig. 3B, dQ/dV bulges upward at a potential of approximately 4.7 V, which indicates occurrence a reaction. In Fig. 4, Eo is constant in the region in a case of the initial product, whereas E and Eo show a proportional relationship in a case of the deteriorated product.

From the above, it can be seen that, in the case of the initial product, oxidation reaction of Ni does not occur in a region of 4.5 V or higher, but oxidation reaction of Ni occurs in the region as the deterioration advances.

It is considered that a phase like $LiNi_{0.5}Mn_{1.5}O_4$ of 5 V spinel has been formed by deterioration. $LiNi_{0.5}Mn_{1.5}O_4$ exists stably in a region of approximately 5 V. In a case of $LiNi_{0.5}Mn_{1.5}O_4$, a redox reaction due to Ni occurs near 4.9 V.

As shown in Fig. 4, the curve is flattened and the reaction converges in the high potential region in the case of the initial product, whereas the reaction advances also in the high potential region in the case of the deteriorated product.

Therefore, at a time of charge or discharge of the energy storage device, the deterioration state of the energy storage device can be estimated by acquiring dQ/dV of a predetermined voltage $V_1$ within the high voltage range.

Since the above-described reaction occurs within the high potential range, the time period $\Delta t$ for reaching a second voltage $V_2$ from a first voltage $V_1$ within the high voltage range of the energy storage device becomes long. By acquiring $\Delta t$, it is possible to estimate the deterioration state of the energy storage device.

Since a gradient $(\Delta(dQ/dV)/\Delta V)$ of V-dQ/dV for reaching the second voltage $V_2$ from the first voltage $V_1$ also changes in accordance the deterioration, it is possible to estimate the deterioration state of the energy storage device by acquiring $[\Delta(dQ/dV)/\Delta V]$.

Also in the high SOC region, it is possible to estimate the deterioration state simply, quickly, and highly accurately.

<First Embodiment>

Hereinafter, as a first embodiment, an energy storage apparatus to be mounted on a vehicle is exemplified.

Fig. 5 shows an example of an energy storage apparatus. An energy storage apparatus 50 includes a plurality of energy storage devices 200, a monitoring device 100, and a housing case 300 to house these. The energy storage apparatus 50 may be used as a power source for an electric vehicle (EV) or a plug-in hybrid electric vehicle (PHEV).

The energy storage device 200 is not limited to a prismatic cell, and may be a cylindrical cell or a pouch cell. The monitoring device 100 may be a circuit board arranged to face the plurality of energy storage devices 200. The monitoring device 100 monitors a state of the energy storage device 200. The monitoring device 100 may be an estimation device. Alternatively, a computer or a server that is connected by wire or wirelessly to the monitoring device 100 may execute an estimation method for estimating energy storage amount characteristics or an energy storage amount on the basis of information outputted from the monitoring device 100.

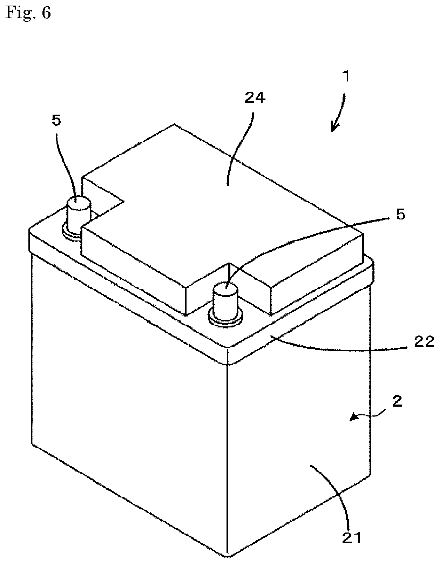

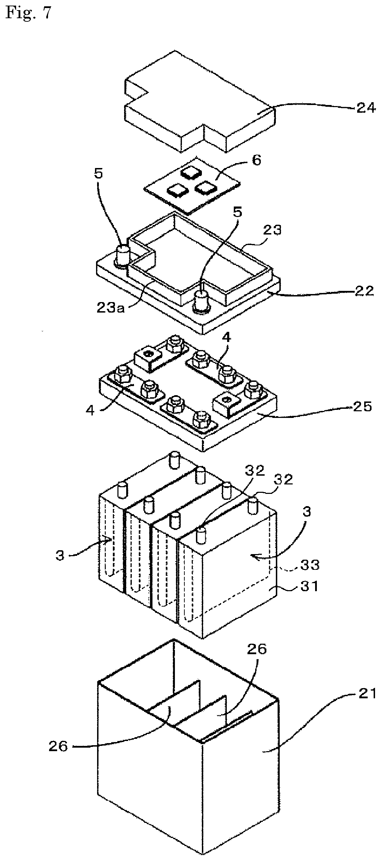

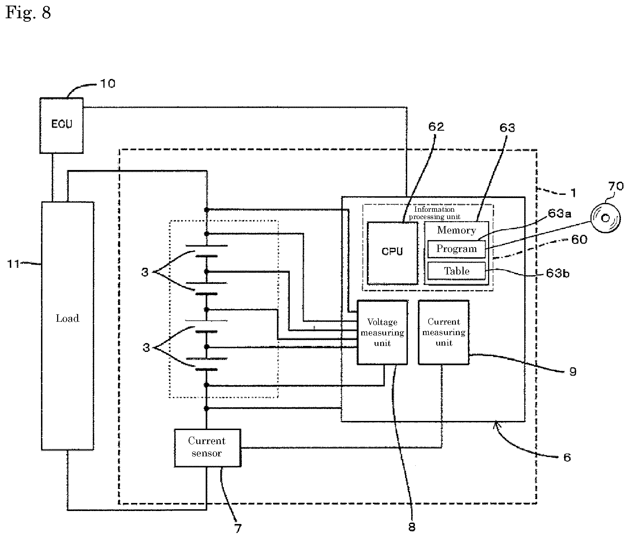

Fig. 6 shows another example of the energy storage apparatus. The energy storage apparatus (hereinafter referred to as a battery module) 1 may be a 12-volt power source or a 48-volt power source that is suitably mounted on an engine vehicle. Fig. 6 is a perspective view of a battery module 1 for 12 V power source, Fig. 7 is an exploded perspective view of the battery module 1, and Fig. 8 is a block diagram of the battery module 1.

The battery module 1 has a rectangular parallelepiped case 2. The case 2 houses a plurality of lithium ion secondary batteries (hereinafter referred to as batteries) 3, a plurality of bus bars 4, a battery management unit (BMU) 6, and a current sensor 7.

The battery 3 includes a rectangular parallelepiped case 31 and a pair of terminals 32 and 32 provided on one side surface of the case 31 and having different polarities. The case 31 houses an electrode assembly 33 in which a positive electrode plate, a separator, and a negative electrode plate are stacked.

In the electrode assembly 33, at least one of a positive active material included in the positive electrode plate or a negative active material included in the negative electrode plate has voltage fade and hysteresis properties.

Examples of the positive active material include a Li-rich active material such as $LiMeO_2$-$Li_2MnO_3$ solid solution, $Li_2O$-$LiMeO_2$ solid solution, $Li_3NbO_4$-$LiMeO_2$ solid solution, $Li_4WO_5$-$LiMeO_2$ solid solution, $Li_4TeO_5$-$LiMeO_2$ solid solution, $Li_3SbO_4$-$LiFeO_2$ solid solution, $Li_2RuO_3$-$LiMeO_2$ solid solution, or $Li_2RuO_3$-$Li_2MeO_3$ solid solution. Examples of the negative active material include hard carbon, metal or alloy such as Si, Sn, Cd, Zn, Al, Bi, Pb, Ge, and Ag, chalcogenides containing these, and the like. An example of the chalcogenide is SiO. The technology of the present invention is applicable as long as at least one of the positive active material or negative active material is included.

The case 2 is made of synthetic resin. The case 2 includes: a case body 21; a lid 22 that closes an opening of the case body 21; a BMU housing 23 provided on an outer surface of the lid 22; a cover 24 that covers the BMU housing 23; an inner lid 25; and a partition plate 26. The inner lid 25 and the partition plate 26 need not be provided. The battery 3 is inserted between the individual partition plates 26 of the case body 21.

The plurality of metal bus bars 4 are placed on the inner lid 25. The inner lid 25 is disposed on a terminal surface provided with the terminal 32 of the battery 3, the adjacent terminals 32 of the adjacent batteries 3 are connected by the bus bar 4, and the batteries 3 are connected in series.

The BMU housing 23 has a box shape, and has a protrusion 23a that protrudes outward in a prismatic shape at a center of one long side surface. On both sides of the protrusion 23a on the lid 22, there are provided a pair of external terminals 5 and 5 made of metal such as lead alloy and having different polarities. The BMU 6 is configured by mounting an information processing unit 60, a voltage measuring unit 8, and a current measuring unit 9 on a substrate. The BMU housing 23 houses the BMU 6, and the cover 24 covers the BMU housing 23, whereby the battery 3 and the BMU 6 are connected.

As shown in Fig. 8, the information processing unit 60 includes the CPU 62 and a memory 63.

In the memory 63, the memory 63 stores various programs 63a including an energy storage amount characteristics estimation program and an energy storage amount estimation program according to the present embodiment, and stores a table 63b that stores energy storage amount characteristics. The program 63a is provided in a state of being stored in a computer-readable recording medium 70 such as a CD-ROM, a DVD-ROM, or a USB memory, for example, and is stored in the memory 63 by being installed in the BMU 6. Alternatively, the program 63a may be acquired from an external computer (not shown) connected to a communication network, and stored in the memory 63. The memory 63, and the first estimation unit, a second estimation unit, or a third estimation unit as a processing unit of the CPU 62 are not limited to a case of being mounted on the BMU 6. It is also possible to mount these in an external device, estimate energy storage amount-potential characteristics, voltage reference energy storage amount-voltage characteristics, or an energy storage amount of the single electrode when a feature value is acquired, and pass a result to the BMU 6.

The energy storage amount characteristics stored in the table 63b will be described with a specific example.

Each cell has been subjected to a cycle test of each No. under conditions of a voltage range, a number of cycles, and a test temperature shown in Table 1 below.

[Table 1]

| No. | Conditions | | |
| --- | --- | --- | --- |
| | Voltage range | Number of cycles | Test temperature |
| 1 | 2.0 - 4.6 V | 0 th | 25°C |
| 2 | 2.0 - 4.6 V | 10 th | 25°C |
| 3 | 2.0 - 4.6 V | 25 th | 25°C |
| 4 | 2.0 - 4.6 V | 50 th | 25°C |
| 5 | 2.0 - 4.6 V | 75 th | 25°C |
| 6 | 2.0 - 4.6 V | 100 th | 25°C |
| 7 | 2.0 - 4.35 V | 500 th | 25°C |
| 8 | 2.0 - 4.475 V | 500 th | 25°C |
| 9 | 2.0 - 4.6 V | 500 th | 25°C |
| 10 | 2.5 - 4.6 V | 500 th | 25°C |

(continued)

|  | Conditions | | |
|-----|-----|-----|-----|
| No. | Voltage range | Number of cycles | Test temperature |
| 11 | 3.0 - 4.6 V | 500 th | 25°C |
| 12 | 3.5 - 4.6 V | 500 th | 25°C |
| 13 | 4.0 - 4.6 V | 500 th | 25°C |
| 14 | 2.0 - 4.35 V | 1000 th | 45°C |
| 15 | 2.0 - 4.6 V | 1000 th | 45°C |

Charge-discharge conditions are as follows.

• Negative electrode: Graphite

• Test rate: charge 0.5 CA, discharge 1.0 CA

Conditions of a confirmation test for obtaining SOC-OCP are as follows.

• Negative electrode: Li metal

• Test rate: charge 0.1 CA, discharge 0.1 CA

• Test temperature: 25°C

As a result, for the test of each No., SOC-OCP characteristics or V-dQ/dV characteristics of the positive electrode are obtained as the energy storage amount characteristics. These energy storage amount characteristics are stored in the table 63b in association with an amount of charge or a discharge capacity in a predetermined voltage range, or the average discharge potential. By each test, the energy storage amount characteristics of the single electrode in a deteriorated state are acquired and arranged in an order of the feature value, and the feature value and the energy storage amount characteristics are associated with each other. It is confirmed that the energy storage amount characteristics change continuously and uniquely in a long term and even if the use history is different.

The CPU 62 executes an energy storage amount characteristics estimation process and an energy storage amount estimation process, which will be described later, in accordance with a program read from the memory 63.

The voltage measuring unit 8 is connected to each of both ends of the battery 3 via a voltage detection line, and measures a voltage of each battery 3 at a predetermined time interval.

The current measuring unit 9 measures a current flowing through the battery 3 via the current sensor 7 at a predetermined time interval.

The external terminals 5 and 5 of the battery module 1 are connected to a starter motor for engine starting and a load 11 such as an electrical component.

An electronic control unit (ECU) 10 is connected to the BMU 6 and the load 11.

Hereinafter, the energy storage amount characteristics estimation method according to the present embodiment will be described.

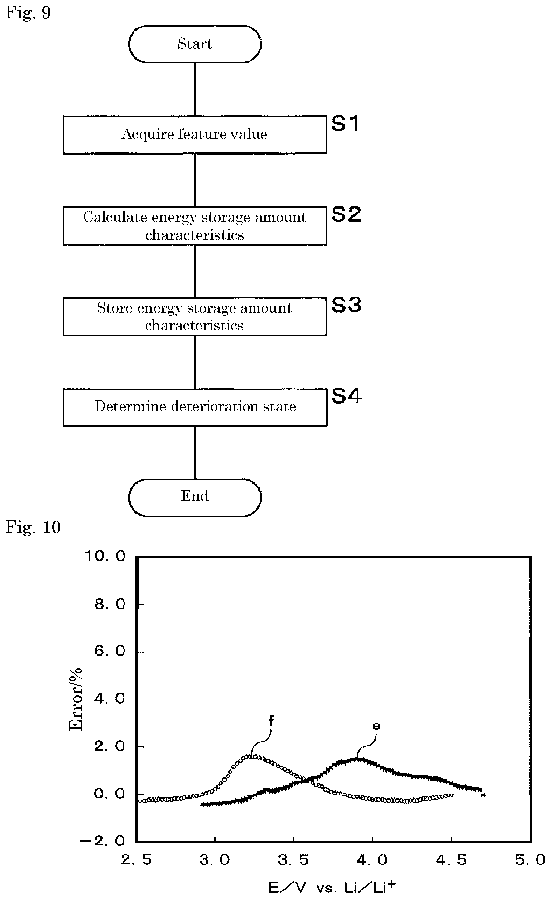

Fig. 9 is a flowchart showing a procedure of the energy storage amount characteristics estimation process by the CPU 62.

The CPU 62 repeats the processing from S1 at a predetermined interval.

The CPU 62 acquires a feature value (S1).

The CPU 62 calculates energy storage amount characteristics corresponding to the acquired feature value. For example, the CPU 62 calculates the target energy storage amount characteristics from energy storage amount characteristics corresponding to two reference feature values by interpolation calculation (S2). Alternatively, the target energy storage amount characteristics are calculated by substituting the acquired feature value into a function of the above-described feature value.

The CPU 62 stores the calculated energy storage amount characteristics in the table 63b (S3).

The CPU 62 estimates a deterioration state of the battery 3 on the basis of the calculated energy storage amount characteristics (S4), and ends the processing. The energy storage amount characteristics are to be an index of deterioration. Note that the processing may be ended after the processing of S3, without performing the processing of S4.

Hereinafter, description will be specifically made.

The CPU 62 acquires, as the feature value, an amount of charge in which a potential range of a single electrode is P1 V to P2 V and a voltage range of a cell is C1 V to C2 V. This amount of charge is defined as QinP1-P2V.

It is assumed that V-dQ/dV data is stored in the table 63b in association with QinP1-P2V for No. 1 to No. 15 in Table 1.

When the acquired feature value is between QinP1-P2V of each of No.2 and No.3, the CPU62 performs the interpolation calculation with use of the V-dQ/dV data of each of No. 2 and No. 3, to acquire V-dQ/dV data corresponding to the feature value.

The acquired V-dQ/dV data can be converted into SOC-OCP data.

Figs. 10 to 20 are graphs showing a result of obtaining an error of SOC-OCP data calculated as described above with respect to SOC-OCP data based on actual measured values. A horizontal axis represents a potential E at a time of charge or discharge (V vs Li/Li$^+$: Li/Li$^+$ potential based on equilibrium potential), and a vertical axis represents an error (%). In the figure, e represents charge data and f represents discharge data.

Fig. 10 is a graph showing the error when No. 2 data is obtained from No. 1 and No. 3 data.

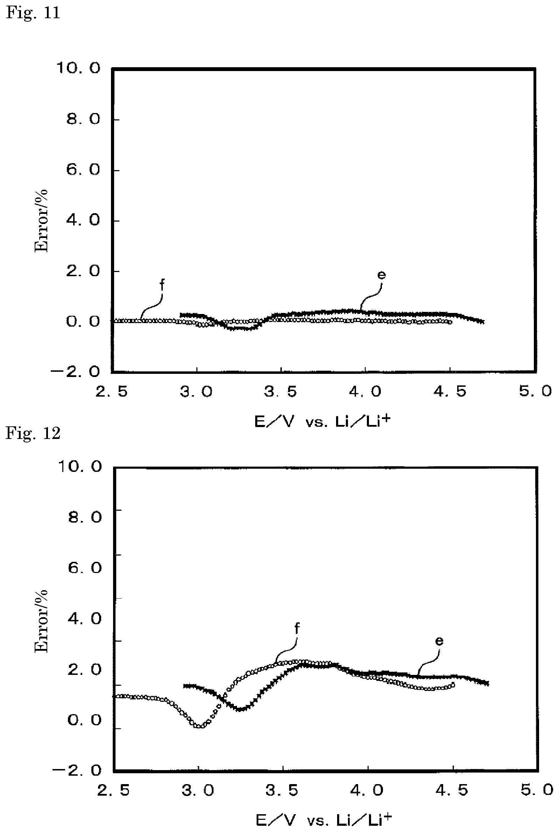

Fig. 11 is a graph showing the error when No. 3 data is obtained from No. 2 and No. 4 data.

Fig. 12 is a graph showing the error when No. 4 data is obtained from No. 3 and No. 7 data.

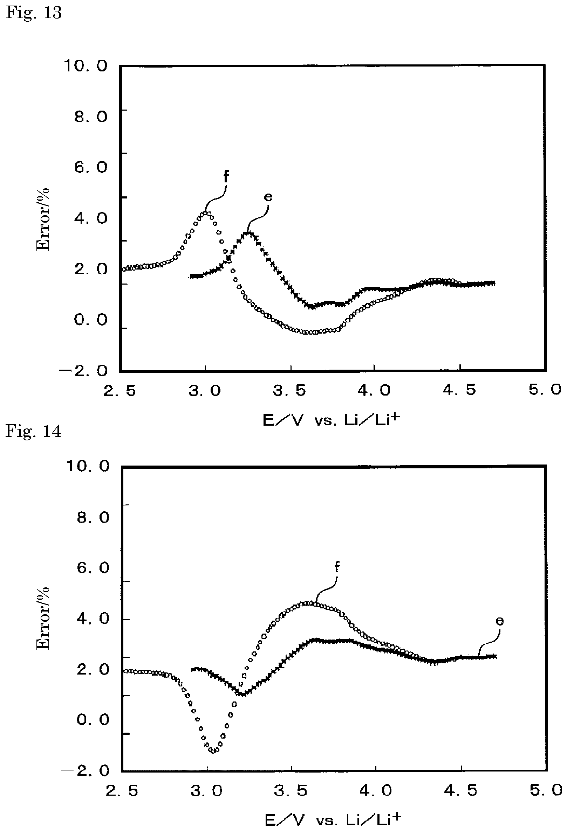

Fig. 13 is a graph showing the error when No. 7 data is obtained from No. 4 and No. 5 data.

Fig. 14 is a graph showing the error when No. 13 data is obtained from No. 5 and No. 6 data.

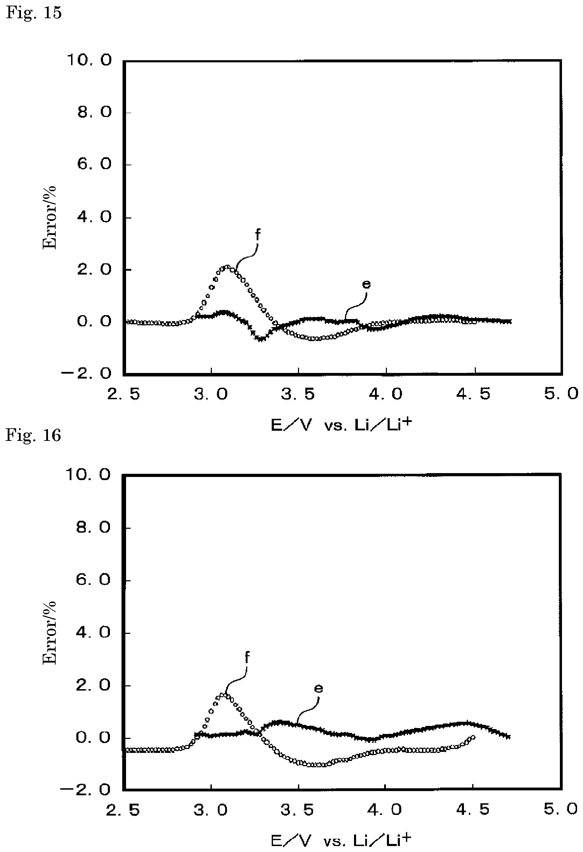

Fig. 15 is a graph showing the error when No. 5 data is obtained from No. 6 and No. 13 data.

Fig. 16 is a graph showing the error when No. 6 data is obtained from No. 12 and No. 13 data.

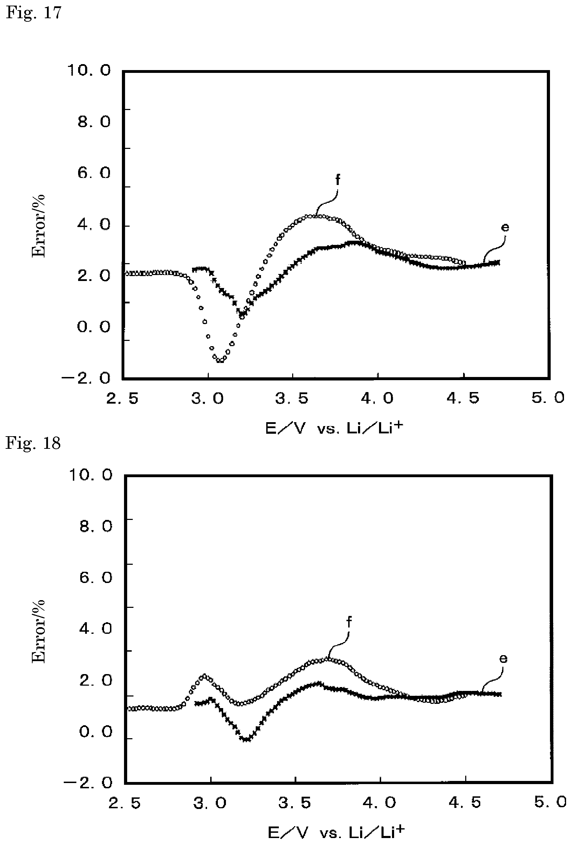

Fig. 17 is a graph showing the error when No. 12 data is obtained from No. 6 and No. 14 data.

Fig. 18 is a graph showing the error when No. 8 data is obtained from No. 11 and No. 14 data.

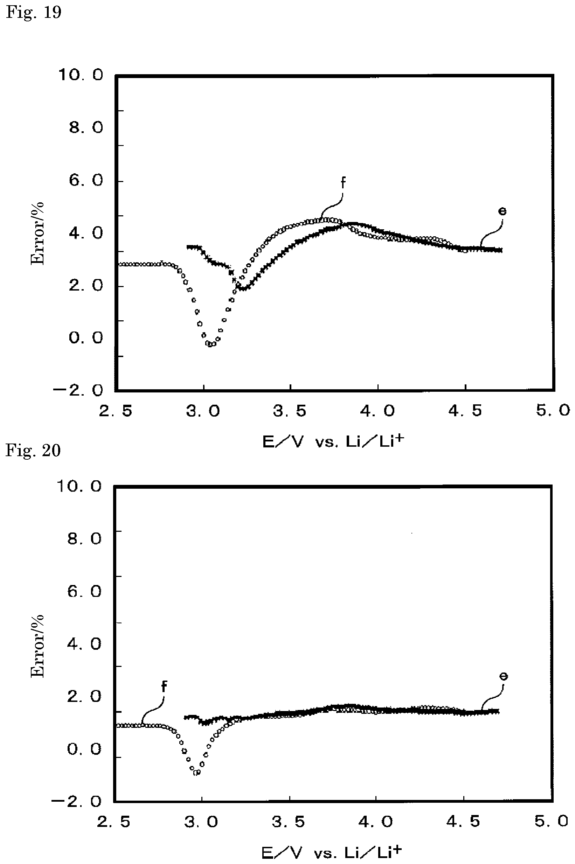

Fig. 19 is a graph showing the error when No. 11 data is obtained from No. 8 and No. 10 data.

Fig. 20 is a graph showing the error when No. 10 data is obtained from No. 9 and No. 11 data.

From Figs. 10 to 20, it can be seen that the calculation error is small, and is even smaller particularly when a potential is in a range of 3.5 V to 4.5 V. Even if data with different test conditions are selected in various combinations, the calculation error is small.

Therefore, it has been confirmed that V-dQ/dV data at a time when the feature value is acquired can be accurately calculated on the basis of V-dQ/dV data corresponding to the feature value and on the basis of the acquired feature value. Since a shape of V-dQ/dV of the positive electrode containing an active material having the voltage fade property changes continuously and uniquely, V-dQ/dV at a time of full charge-discharge at the present moment can be calculated accurately even when data with different test conditions is used. It is only necessary to store a part of change transition of V-dQ/dV with respect to a change in the feature value. The number of V-dQ/dV data to be stored in the table 63b can be reduced.

Hereinafter, description will be made on a case where SOC is estimated with use of the most recently calculated V-dQ/dV data.

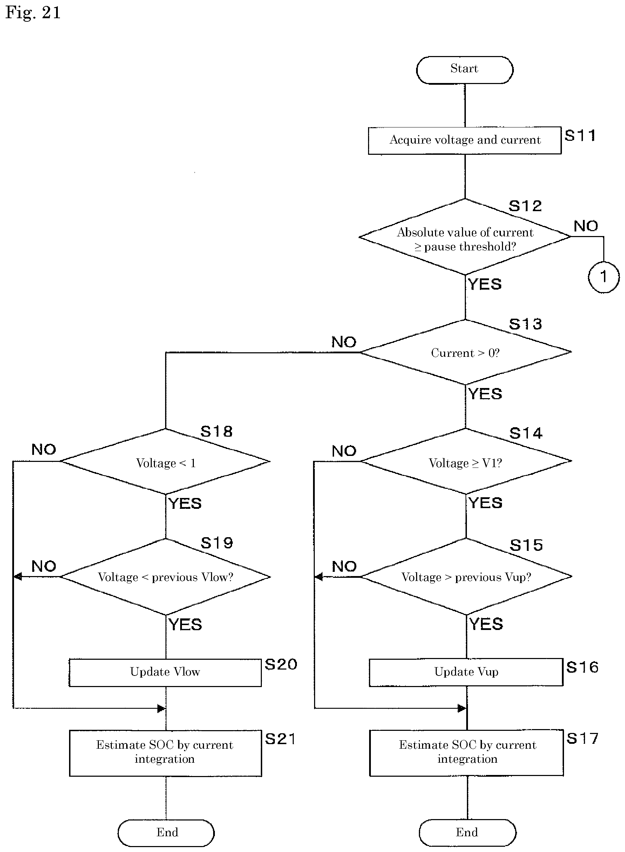

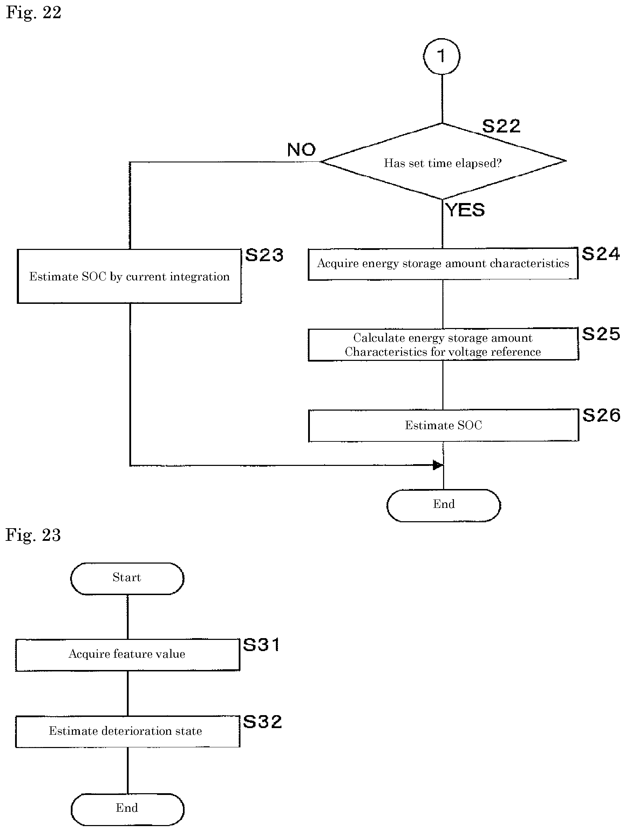

Figs. 21 and 22 are flowcharts showing a procedure of an SOC estimation process performed by the CPU 62. The CPU 62 repeats the processing from S11 at a predetermined interval.

A voltage with a small oxidation amount and a small reduction amount of reaction causing hysteresis is obtained in advance through experiments, and is set as a threshold V1. A voltage acquired after a voltage becomes nobler than V1 is set as an upper reference voltage (Vup). The Vup is updated when the acquired voltage is higher than the previously acquired voltage. A voltage acquired after a voltage becomes poorer than V1 is set to a lower reference voltage (Vlow). The Vlow is updated when the acquired voltage is smaller than the previously acquired voltage.

The CPU 62 acquires a voltage and a current between terminals of the battery 3 (S11). Since the threshold V1 and the upper reference voltage Vup are OCV, it is necessary to correct the acquired voltage to OCV when a current amount of the battery 3 is large. A correction value to OCV can be obtained by estimating a voltage when the current is zero, and the like, with use of a regression line from a plurality of voltage and current data. When a current amount flowing through the battery 3 is as small as a dark current (is a minute current), the acquired voltage is regarded as OCV.

The CPU 62 determines whether or not an absolute value of the current is equal to or greater than a pause threshold (S12). The pause threshold is set in order to determine whether a state of the battery 3 is a charge state, a discharge state, or a pause state. When the CPU 62 determines that the absolute value of the current is not equal to or greater than the pause threshold (S12: NO), the processing proceeds to S22.

When the CPU 62 determines that the absolute value of the current is equal to or greater than the pause threshold (S12: YES), the CPU 62 determines whether or not the current is larger than 0 (S13). When the current is larger than 0, it is determined that the state of the battery 3 is the charge state. When the CPU 62 determines that the current is not greater than 0 (S13: NO), the processing proceeds to S18.

When the CPU 62 determines that the current is larger than 0 (S13: YES), the CPU 62 determines whether or not the voltage is equal to or higher than V1 (S14). When the CPU 62 determines that the voltage is not equal to or higher than V1 (S14: NO), the processing proceeds to S17.

When the CPU 62 determines that the voltage is equal to or higher than V1 (S14: YES), the CPU 62 determines whether or not the acquired voltage is greater than Vup that is previously stored in the memory 63 (S15). When the CPU 62 determines that the voltage is not higher than the previous Vup (S15: NO), the processing proceeds to S17.

When the CPU 62 determines that the voltage is higher than the previous Vup (S15: YES), the CPU 62 updates the voltage to Vup in the memory 63 (S16).

The CPU 62 estimates SOC by current integration (S17) and ends the processing.

When the CPU 62 determines that the current is smaller than 0 and the state of the battery 3 is the discharge state (S13: NO), the CPU 62 determines whether or not the voltage is lower than V1 (S18). When the CPU 62 determines that the voltage is not lower than V1 (S18: NO), the processing proceeds to S21.

When the CPU 62 determines that the voltage is lower than V1 (S18: YES), the CPU 62 determines whether or not the acquired voltage is lower than the lower reference voltage Vlow that is previously stored in the memory 63 (S19).

When the CPU 62 determines that the voltage is not lower than the previous Vlow (S19: NO), the processing proceeds to S21.

When the CPU 62 determines that the voltage is lower than the previous Vup (S19: YES), the voltage is updated to Vlow in the memory 63 (S20).

The CPU 62 estimates SOC by current integration (S21) and ends the processing.

When the CPU 62 determines that the absolute value of the current is smaller than the pause threshold and the state of the battery 3 is the pause state (S12: NO), the CPU 62 determines whether or not a set time period has elapsed (S22). The set time period is a time period obtained by an experiment and is sufficient to regard the acquired voltage as OCV. The CPU 62 determines whether or not the time period has been exceeded, on the basis of a number of current acquisitions and an acquisition interval since the determination as the pause state. This allows the SOC to be estimated with higher accuracy in the pause state.

When the CPU 62 determines that the set time period has not elapsed (S22: NO), the CPU 62 estimates SOC by current integration (S23) and ends the processing.

When the CPU 62 determines that the set time period has elapsed (S22: YES), the acquired voltage can be regarded as OCV.

The CPU 62 acquires the most recent energy storage amount characteristics from the table 63b (S24). In a case where there is a period from the date of the last acquisition of the feature value, in consideration of a history from the acquisition to the present moment, it is preferable to correct the estimated energy storage amount characteristics, or newly obtain the energy storage amount characteristics to update.

The CPU 62 calculates energy storage amount characteristics for voltage reference on the basis of the acquired energy storage amount characteristics (S25). For example, when the energy storage amount characteristics are V-dQ/dV of the positive electrode, the CPU 62 converts into V-dQ/dV of the cell. The CPU 62 calculates charge SOC-OCV or discharge SOC-OCV of the cell on the basis of the cell V-dQ/dV. On the basis of the charge SOC-OCV or discharge SOC-OCV, and Vup, the CPU 62 calculates charge SOC-OCV (third characteristic) for voltage reference or discharge SOC-OCV (fourth characteristic) for voltage reference. For example, in consideration of an oxidation amount and a reduction amount of reaction causing hysteresis, the CPU 62 uses the charge SOC-OCV or discharge SOC-OCV to calculate charge SOC-OCV or discharge SOC-OCV for voltage reference.

The CPU 62 estimates SOC by reading SOC corresponding to the voltage acquired in S1, in the charge SOC-OCV or the discharge SOC-OCV for voltage reference (S26), and ends the processing.

Note that the voltage acquired by the CPU 62 from the voltage measuring unit 8 varies to an extent depending on the current, and therefore a correction coefficient can also be obtained by experiment to correct the voltage.

As described above, in the present embodiment, the feature value at the present moment is acquired, the stored energy storage amount-voltage characteristics or V-dQ/dV or function thereof is referred to, and the energy storage amount-potential characteristics or V-dQ/dV at the present moment is estimated.

In a case of using the energy storage device having the active material in which energy storage amount-potential characteristics of the single electrode are changed by repeated charge-discharge, the energy storage amount-potential characteristics or V-dQ/dV of the single electrode at the present moment can be estimated with high accuracy by a simple method from a feature value alone. The number of V-dQ/dV data to be stored in the table 63b can be reduced.

The present energy storage amount-potential characteristics or V-dQ/dV of the single electrode is to be an index indicating a current deterioration state. Therefore, the deterioration state of the single electrode can be monitored with high accuracy even in a complicated use environment.

In a case of using an amount of charge or a discharge capacity in a predetermined voltage range as the feature value, and storing a plurality of energy storage amount-potential characteristics or pieces of V-dQ/dV in association with a feature value corresponding to a deterioration degree, the energy storage amount-potential characteristics or V-dQ/dV at the present moment can be accurately estimated. This similarly applies to a case of an average discharge potential.

When the active material has hysteresis, the energy storage amount-voltage characteristics for voltage reference can be accurately estimated on the basis of the energy storage amount-potential characteristics according to the current deterioration state of the single electrode and on the basis of the charge-discharge history of the energy storage device. By using together knowledge of a behavior of hysteresis for the energy storage device containing the active material having the voltage fade property, an energy storage amount can be estimated satisfactorily and easily.

Since the voltage is used, it is possible to estimate a current energy amount stored in the energy storage device, such as watt-hour, as the energy storage amount, without limiting to SOC. On the basis of the charge-discharge characteristics, dischargeable energy up to SOC 0% and charge energy required up to SOC 100% can be predicted. Remaining watt-hour and storable watt-hour at the present moment can be estimated.

Therefore, it is possible to accurately perform: balancing in a case of using a plurality of energy storage devices; control of regenerative acceptance; estimation of a travel distance when the energy storage device is mounted on a vehicle; and the like.

<Second Embodiment>

A CPU 62 of an information processing unit 60 of a battery module according to a second embodiment acquires, as a feature value, any one of, within a high voltage range, dQ/dV at a predetermined voltage $V_0$, a time period $\Delta t$ for reaching a second voltage $V_2$ from a first voltage $V_1$, and a gradient $[\Delta(dQ/dV)/\Delta V]$ of V-dQ/dV between the first voltage $V_1$ and the second voltage $V_2$. The CPU 62 estimates a deterioration state of a battery 3 on the basis of the feature value.

As shown in Fig. 4, a curve is flattened and a reaction converges in a high potential region in a case of an initial product, whereas the reaction advances also in the high potential region in a case of a deteriorated product. Since dQ/dV at $V_0$ within the high voltage range of the battery 3 is changed by deterioration, the deterioration state of the battery 3 can be estimated by acquiring the dQ/dV at a time of charge or discharge of the battery 3.

Since the above-described reaction occurs within the high potential range, the time period $\Delta t$ for reaching the second voltage $V_2$ from the first voltage $V_1$ within the high voltage range of the energy storage device becomes long. By acquiring $\Delta t$, it is possible to estimate a deterioration state of the energy storage device.

Since the gradient $[\Delta(dQ/dV)/\Delta V]$ of V-dQ/dV between the first voltage $V_1$ and the second voltage $V_2$ also changes in accordance the deterioration, it is possible to estimate the deterioration state of the energy storage device by acquiring $\Delta(dQ/dV)/\Delta V$.

The high voltage range is preferably 4.4 V to 5.0 V. For the voltages $V_0$, $V_1$, and $V_2$, with reference to Fig. 4, Figs. 24 and 25 to be described later, and the like, a voltage is selected in which a change amount in the feature value increases in accordance with deterioration at each time of charge and discharge.

A table 63b of a memory 63 stores any of a relationship between a number of cycles and the dQ/dV, a relationship between a number of cycles and the $\Delta t$, and a relationship between a number of cycles and $\Delta(dQ/dV)/\Delta V$, which are obtained by an experiment in advance. These relationships may be converted into functions to be stored in the memory 63. The above relationships or functions may be stored by rates. The memory 63 may also store a relationship between a feature value and SOH.

Fig. 23 is a flowchart showing a procedure of a deterioration state estimation process by the CPU 62.

On the basis of a charge-discharge history, the CPU 62 acquires a feature value that is any one of dQ/dV, $\Delta t$, and $\Delta(dQ/dV)/\Delta V$ (S31).

The CPU 62 reads a relationship between a number of cycles and dQ/dV, $\Delta t$, or $\Delta(dQ/dV)/\Delta V$ from the table 63b in correspondence with the feature value. The CPU 62 refers to the read relationship, estimates whether or not the battery 3 at the present moment is in a deterioration state on the basis of the acquired feature value (S32), and ends the processing.

The CPU 62 estimates the deterioration state in consideration of a usage status of a user of the battery 3, usage conditions, a deterioration determination criteria inputted from the user, and the like. The CPU 62 may estimate the deterioration state on the basis of a relationship between the feature value and the SOH. The CPU 62 may estimate the deterioration state on the basis of the function described above.

(Modification 1)

The table 63b of the memory 63 of Modification 1 stores a threshold of a feature value set for estimating a deterioration state on the basis of a relationship between a number of cycles and dQ/dV, $\Delta t$, or $\Delta(dQ/dV)/\Delta V$.

In this case, in S32, the CPU 62 reads a threshold corresponding to the feature value acquired in S31 from the table 63b, and estimates a deterioration state of the battery 3 on the basis of the threshold.

When dQ/dV, $\Delta t$, or $\Delta(dQ/dV)/\Delta V$ is acquired at a time of charge of the battery 3, the CPU 62 estimates that the battery 3 is in a deterioration state when the feature value is equal to or greater than the threshold.

When dQ/dV or $\Delta t$ is acquired as the feature value at a time of discharge of the battery 3, the CPU 62 estimates that the battery 3 is in a deterioration state when |dQ/dV| or $\Delta t$ is equal to or greater than the threshold. In a case of using dQ/dV as a negative number, the CPU 62 estimates that the battery 3 is in a deterioration state when dQ/dV is equal to or smaller than the threshold.

When $\Delta$(dQ/dV)/$\Delta$V is acquired as the feature value, the CPU 62 estimates that the battery 3 is in a deterioration state when the feature value is equal to or smaller than the threshold.

(Modification 2)

In the table 63b of the memory 63 of Modification 2, a plurality of pieces of V-dQ/dV corresponding to deterioration over time are stored in association with a feature value.

Similarly to the first embodiment, the CPU 62 estimates a deterioration state with a procedure shown in Fig. 9.

The CPU 62 acquires a feature value that is any one of dQ/dV, $\Delta$t, and $\Delta$(dQ/dV)/$\Delta$V (S1).

The CPU 62 calculates target energy storage amount characteristics (V-dQ/dV) corresponding to the acquired feature value. For example, the CPU 62 calculates the target energy storage amount characteristics from energy storage amount characteristics corresponding to two reference feature values by interpolation calculation (S2). Alternatively, the target energy storage amount characteristics are calculated by substituting the acquired feature value into a function of the feature value.

The CPU 62 stores the calculated energy storage amount characteristics in the table 63b (S3).

The CPU 62 estimates a deterioration state of the battery 3 on the basis of the calculated energy storage amount characteristics (S4), and ends the processing. The obtained energy storage amount characteristics are to be an index of deterioration.

By obtaining SOC-OCV on the basis of the obtained V-dQ/dV, and obtaining SOC-OCV for voltage reference on the basis of the SOC-OCV and a charge-discharge history, SOC at a time when the feature value is acquired can be calculated by the OCV method.

(Example)

Hereinafter, an example of the second embodiment will be specifically described, but the present invention is not limited to this example.

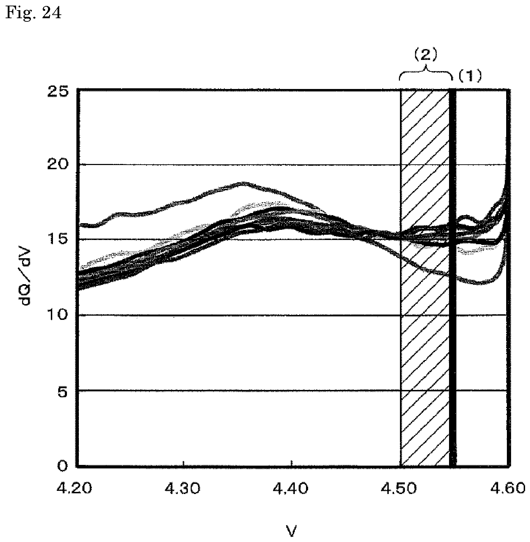

The battery 3 of the example was manufactured using the above-described Li-rich active material as the positive active material and graphite as the negative active material. A charge-discharge cycle test was performed using this battery 3, and V-dQ/dV at a time of charge was obtained in correspondence with a plurality of cycles from the 10th to the 480th cycle. Fig. 24 shows results thereof. A horizontal axis represents a voltage (V), and a vertical axis represents dQ/dV.

In the charge-discharge cycle test, CC charge was performed under a condition of a temperature of 25°C until the voltage reached 4.6 V at 0.5 C, CV charge was performed at 4.6 V until the current reached 0.1 C, and a pause was given for 10 minutes. Thereafter, CC discharge was performed until the voltage reached 2.0 V at 1.0 C, and a pause was given for 10 minutes. The charge-discharge was repeated with this as one cycle.

Fig. 24 is a graph showing a result of obtaining V-dQ/dV at a time of discharge, in correspondence with the plurality of cycles described above. A horizontal axis represents a voltage (V), and a vertical axis represents dQ/dV.

In Fig. 24, an upper curve has a larger number of cycles than that of a lower curve. As shown in Fig. 24, it can be seen that dQ/dV at 4.55 V in (1) increases as the number of cycles increases.

In a range of 4.50 V to 4.55 V in (2), as the number of cycles increases, a V-dQ/dV curve becomes convex upward, and more oxidation reactions occur. Therefore, the time period $\Delta$t for reaching from 4.50 V to 4.55 V becomes longer. The gradient $\Delta$(dQ/dV)/$\Delta$V in the range of (2) increases as the number of cycles increases.

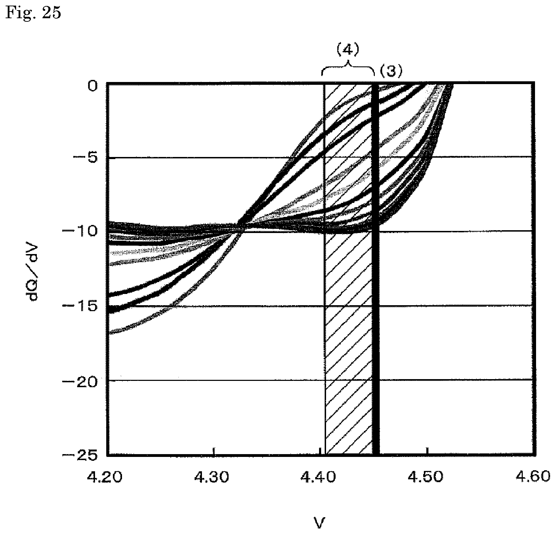

Fig. 25 is a graph showing a result of obtaining V-dQ/dV at a time of discharge, in correspondence with the plurality of cycles described above. A horizontal axis represents a voltage (V), and a vertical axis represents dQ/dV.

In Fig. 25, a lower curve has a larger number of cycles than that of an upper curve. As shown in Fig. 25, it can be seen that an absolute value of dQ/dV at 4.45 V in (3) increases as the number of cycles increases.

In a range of 4.40 V to 4.45 V in (4), as the number of cycles increases, a V-dQ/dV curve becomes convex downward, and more reductive reactions occur. Therefore, the time period $\Delta$t for reaching 4.40 V from 4.45 V becomes longer. The gradient [$\Delta$(dQ/dV)/$\Delta$V] in the range of (4) decreases as the number of cycles increases.

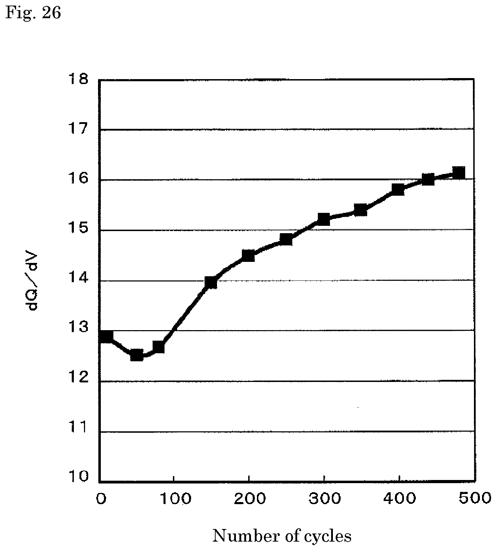

Fig. 26 is a graph showing a result of obtaining a relationship between a number of cycles of the battery 3 and dQ/dV at 4.55 V at a time of charge. A horizontal axis represents a number of cycles, and a vertical axis represents dQ/dV.

As shown in Fig. 26, dQ/dV increases as the number of cycles increases.

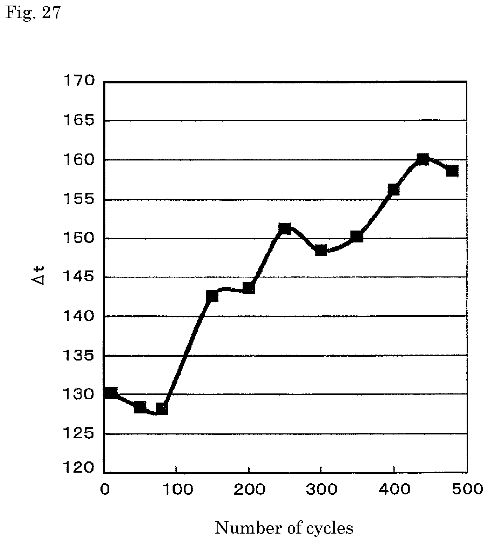

Fig. 27 is a graph showing a result of obtaining a relationship between a number of cycles of the battery 3 and a time period $\Delta$t in which a voltage at a time of charge reaches 4.55 V from 4.50 V. A horizontal axis represents a number of cycles, and a vertical axis represents $\Delta$t.

As shown in Fig. 27, $\Delta$t increases as the number of cycles increases.

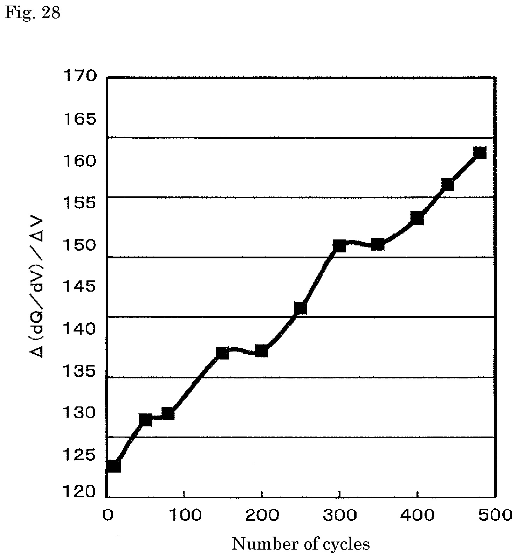

Fig. 28 is a graph showing a number of cycles of the battery 3 and a result of obtaining a gradient [Δ(dQ/dV)/ΔV] of a V-dQ/dV curve between voltages 4.50 V and 4.55 V at a time of charge. A horizontal axis represents a number of cycles, and a vertical axis represents Δ(dQ/dV)/ΔV.

As shown in Fig. 28, Δ(dQ/dV)/ΔV increases as the number of cycles increases.

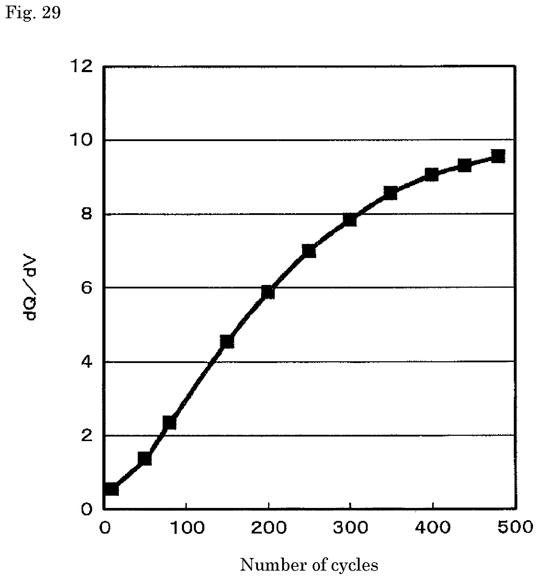

Fig. 29 is a graph showing a number of cycles of the battery 3 and a result of obtaining |dQ/dV| at 4.45 V at a time of discharge. A horizontal axis represents a number of cycles, and a vertical axis represents |dQ/dV|.

As shown in Fig. 29, |dQ/dV| increases as the number of cycles increases.

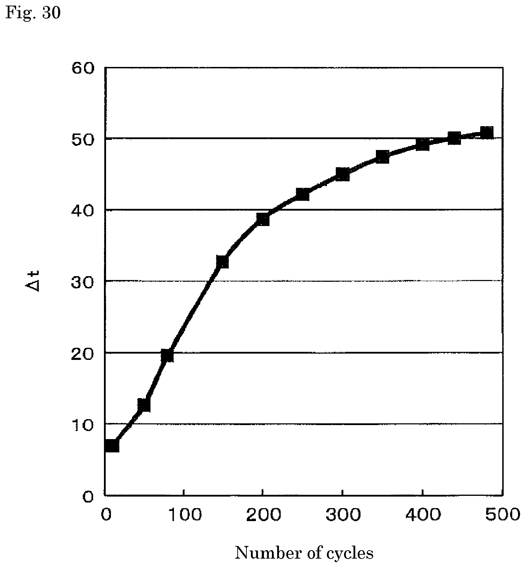

Fig. 30 is a graph showing a result of obtaining a relationship between a number of cycles of the battery 3 and a time period Δt in which a voltage at a time of discharge reaches 4.40 V from 4.45 V. A horizontal axis represents a number of cycles, and a vertical axis represents Δt.

As shown in Fig. 30, Δt increases as the number of cycles increases.

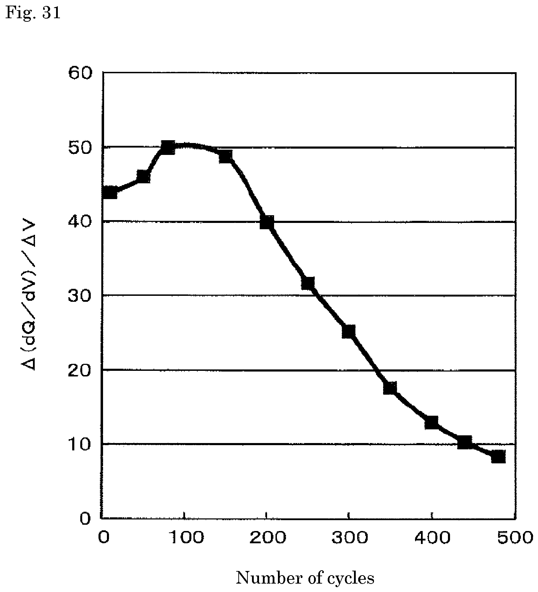

Fig. 31 is a graph showing a number of cycles of the battery 3 and a result of obtaining a gradient [Δ(dQ/dV)/ΔV] of a V-dQ/dV curve between 4.45V and 4.40V at a time of discharge. A horizontal axis represents a number of cycles, and a vertical axis represents Δ(dQ/dV)/ΔV.

As shown in Fig. 31, Δ(dQ/dV)/ΔV decreases as the number of cycles increases.

As described above, when the active material having voltage fade is used, dQ/dV, Δt, and (Δ(dQ/dV)/ΔV) change characteristically with deterioration in the high voltage range.

By storing a relationship between the number of cycles and dQ/dV, Δt, or Δ(dQ/dV)/ΔV in the table 63b, and associating SOH with a change amount in the feature value with an increase in the number of cycles, it is possible to satisfactorily estimate a deterioration state at a time when the feature value is acquired. The deterioration state can also be satisfactorily determined by the threshold of the feature value.

In a case of charging in an unused period of the night after using the vehicle, the deterioration state can be estimated easily and quickly at a start-time of use on the basis of the feature value in the high voltage range. Therefore, it is highly convenient.

Since the deterioration state can be accurately estimated, control for suppressing deterioration can be performed at an appropriate timing, and service life of the battery 3 can be extended.

The deterioration state can be estimated within a range of normal use conditions, and the battery 3 does not deteriorate when the deterioration state is estimated.

The present invention is not limited to the contents of the above-described embodiments, and various modifications can be made within the scope shown in the claims. That is, embodiments obtained by combining technical means appropriately changed within the scope of the claims are also included in the technical scope of the present invention.

In the first and second embodiments, description has been made on the case where the positive electrode contains the active material having voltage fade and hysteresis. However, also in a case where the negative electrode contains the active material having voltage fade and hysteresis, the energy storage amount-potential characteristics or V-dQ/dV can be similarly estimated.

The estimation of the energy storage amount by voltage reference according to the present invention is not limited to the case of being performed during a pause, and may be performed in real time at a time of charge or discharge. In this case, OCV at the present moment is calculated from the acquired voltage and current. The calculation of the OCV can be obtained by estimating a voltage when a current is zero, and the like, with use of a regression line from a plurality of voltage and current data. In addition, when the current is as small as dark current, the acquired voltage can be read as the OCV.

The estimation device according to the present invention is not limited to the case of being applied to an in-vehicle lithium ion secondary battery, and can also be applied to other energy storage apparatuses such as a railway regenerative power storing apparatus and a solar power generating system. Further, the estimation device according to the present invention can also be applied to mobile equipment such as a notebook computer, a mobile phone, and a shaver. In an energy storage apparatus in which a minute current flows, a voltage between the positive electrode terminal and the negative electrode terminal of the energy storage device can be regarded as OCV.

The case where the monitoring device 100 or the BMU 6 is the estimation device has been exemplified. Alternatively, a cell monitoring unit (CMU) may be the estimation device. The estimation device may be a part of a battery module incorporated with the monitoring device 100 or the like. The estimation device may be configured separately from the energy storage device and the battery module, and connected to the battery module including the energy storage device whose deterioration state is to be estimated, when the deterioration state is estimated. The estimation device may remotely monitor the energy storage device and the battery module.

The energy storage device is not limited to a lithium ion secondary battery, and may be another secondary battery or an electrochemical cell having voltage fade and hysteresis properties.

INDUSTRIAL APPLICABILITY

The present invention can be applied to estimation of a deterioration state of an energy storage device such as a lithium ion secondary battery.

DESCRIPTION OF REFERENCE SIGNS

1, 50: battery module (energy storage apparatus)
2: case
21: case body
22: lid
23: BMU housing
24: cover
25: inner lid
26: partition plate
3, 200: battery (energy storage device)
31: case
32: terminal
33: electrode assembly
4: bus bar
5: external terminal
6: BMU (estimation device)
60: information processing unit
62: CPU (acquisition unit, first estimation unit, second estimation unit, third estimation unit)
63: memory (storage unit)
63a: program
63b: table
7: current sensor
8: voltage measuring unit
9: current measuring unit
10: ECU
100: monitoring device (estimation device)
300: housing case

**Claims**

1.  An estimation device for estimating at least one of a first characteristic, a second characteristic, and V-dQ/dV that is a relationship between a potential V and dQ/dV, of a single electrode of an energy storage device having the single electrode containing an active material in which repeated charge-discharge changes the first characteristic that is an energy storage amount-potential charge characteristic, and the second characteristic that is an energy storage amount-potential discharge characteristic, the estimation device comprising:

    a storage unit that stores a plurality of at least any of first characteristics, second characteristics, or pieces of V-dQ/dV of the single electrode in accordance with a change in a feature value, which is changed by repeated charge-discharge, or stores as a function of the feature value;
    an acquisition unit that acquires the feature value of the energy storage device; and
    a first estimation unit that refers to at least one of the first characteristic, the second characteristic, or the V-dQ/dV, or refers to the function, in accordance with the feature value acquired by the acquisition unit, to estimate at least one of the first characteristic, the second characteristic, and the V-dQ/dV of the single electrode.

2.  The estimation device according to claim 1, wherein the feature value is an amount of charge or a discharge capacity in a predetermined voltage range, or an average discharge potential.

3.  The estimation device according to claim 2, wherein

in accordance with magnitude of the amount of charge or the discharge capacity, or the average discharge potential, the storage unit stores a plurality of pieces of V-dQ/dV or has stored the function, and the first estimation unit refers to a relationship between the feature value and the V-dQ/dV, to estimate V-dQ/dV of the single electrode.

4. The estimation device according to claim 2 or 3, wherein the amount of charge or the discharge capacity is corrected in accordance with a deterioration degree of the active material.

5. The estimation device according to claim 1, wherein the feature value is any one of, within a high voltage range, dQ/dV at a predetermined voltage, a time period for reaching a second voltage from a first voltage, and a gradient [Δ(dQ/dV)/ΔV] of V-dQ/dV between a first voltage and a second voltage.

6. An estimation device for estimating a deterioration state of an energy storage device having a single electrode containing an active material in which repeated charge-discharge changes a first characteristic that is an energy storage amount-potential charge characteristic, and a second characteristic that is an energy storage amount-potential discharge characteristic, the estimation device comprising:

   an acquisition unit that acquires a feature value that is any one of, within a high voltage range, dQ/dV at a predetermined voltage, a time period for reaching a second voltage from a first voltage, and a gradient [Δ(dQ/dV)/ΔV] of V-dQ/dV between a first voltage and a second voltage; and
   an estimation unit that estimates a deterioration state of the energy storage device in accordance with the feature value.

7. The estimation device according to claim 6, wherein the estimation unit estimates a deterioration state of the energy storage device in accordance with a threshold of the feature value.

8. The estimation device according to any one of claims 1 to 5, wherein

   the active material exhibits hysteresis between a first characteristic and a second characteristic,
   the estimation device comprising a second estimation unit that estimates a third characteristic that is an energy storage amount-voltage charge characteristic for reference and/or a fourth characteristic that is an energy storage amount-voltage discharge characteristic for reference in estimating an energy storage amount with a voltage of the energy storage device, in accordance with the first characteristic and/or the second characteristic estimated by the first estimation unit, and in accordance with a charge-discharge history of the energy storage device.

9. The estimation device according to claim 8, further comprising a third estimation unit that estimates an energy storage amount in accordance with a charge-discharge history, the third characteristic and/or the fourth characteristic, and an acquired voltage.

10. An energy storage apparatus comprising:

   an energy storage device; and
   the estimation device according to any one of claims 1 to 9.

11. An estimation method for estimating at least one of a first characteristic, a second characteristic, and V-dQ/dV that is a relationship between a potential V and dQ/dV, of a single electrode of an energy storage device having the single electrode containing an active material in which repeated charge-discharge changes the first characteristic that is an energy storage amount-potential charge characteristic, and the second characteristic that is an energy storage amount-potential discharge characteristic, the estimation method comprising:

   storing a plurality of at least any of first characteristics, second characteristics, or pieces of V-dQ/dV of the single electrode in accordance with a change in a feature value, which is changed by repeated charge-discharge, or having stored as a function of the feature value; and
   referring to at least one of the first characteristic, the second characteristic, or the V-dQ/dV, or referring to the function, in accordance with an acquired feature value, to estimate at least one of the first characteristic, the second characteristic, and the V-dQ/dV of the single electrode.

**12.** An estimation method for estimating a deterioration state of an energy storage device having a single electrode containing an active material in which repeated charge-discharge changes an energy storage amount-potential charge characteristic and an energy storage amount-potential discharge characteristic, the estimation method comprising:

acquiring a feature value that is any one of, within a high voltage range, dQ/dV at a predetermined voltage, a time period for reaching a second voltage from a first voltage, and a gradient $[\Delta(dQ/dV)/\Delta V]$ of V-dQ/dV between a first voltage and a second voltage; and

estimating a deterioration state of the energy storage device in accordance with the feature value.

**13.** A computer program for causing a computer that estimates at least one of a first characteristic, a second characteristic, and V-dQ/dV that is a relationship between a potential V and dQ/dV, of a single electrode of an energy storage device having the single electrode containing an active material in which repeated charge-discharge changes the first characteristic that is an energy storage amount-potential charge characteristic, and the second characteristic that is an energy storage amount-potential discharge characteristic, to execute processing of:

acquiring a feature value that is changed by repeated charge-discharge of the energy storage device; and referring to a table that stores a plurality of at least any of first characteristics, second characteristics, or pieces of V-dQ/dV of the single electrode in accordance with a change in the feature value, or referring to a function stored as the function of the feature value, to estimate at least one of the first characteristic, the second characteristic, and the V-dQ/dV of the single electrode, in accordance with the acquired feature value.

**14.** A computer program for causing a computer that estimates a deterioration state of an energy storage device having a single electrode containing an active material in which repeated charge-discharge changes an energy storage amount-potential charge characteristic and an energy storage amount-potential discharge characteristic, to execute processing of:

acquiring a feature value that is any one of, within a high voltage range, dQ/dV at a predetermined voltage, a time period for reaching a second voltage from a first voltage, and a gradient $[\Delta(dQ/dV)/\Delta V]$ of V-dQ/dV between a first voltage and a second voltage; and

estimating a deterioration state of the energy storage device in accordance with the feature value.

Fig. 1

Fig. 2

Amount of charge/%

Fig. 3

A

B

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

```
                                    ┌──────────┐
                                    │   Start  │
                                    └────┬─────┘
                                         │
                              ┌──────────┴────────────┐
                              │ Acquire voltage and current │  S11
                              └──────────┬────────────┘
                                         │
                                    ╱────┴────╲                S12
                                 ╱ Absolute value of ╲    NO
                                ╱  current ≥ pause     ╲────────┐
                                ╲    threshold?        ╱        │
                                 ╲───────┬────╱               ( 1 )
                                      YES │
                                    ╱─────┴─────╲              S13
                        NO       ╱               ╲
                  ┌─────────────╱   Current > 0?   ╲
                  │             ╲                  ╱
                  │              ╲────────┬───────╱
                  │                    YES │
            ╱─────┴─────╲                ╱─┴──────╲           S14
    NO     ╱             ╲  S18  NO    ╱            ╲
  ┌───────╱  Voltage < 1  ╲    ┌──────╱ Voltage ≥ V1? ╲
  │       ╲               ╱    │      ╲               ╱
  │        ╲─────┬───────╱     │       ╲──────┬──────╱
  │            YES │           │           YES │
  │       ╱────────┴────╲ S19  │        ╱──────┴──────╲       S15
  │  NO  ╱               ╲      │   NO  ╱               ╲
  │◄────╱ Voltage < previous╲   │◄─────╱ Voltage > previous╲
  │     ╲    Vlow?         ╱    │      ╲    Vup?          ╱
  │      ╲───────┬────────╱     │       ╲──────┬─────────╱
  │          YES │             │           YES │
  │     ┌────────┴──────┐ S20  │      ┌────────┴───────┐   S16
  │     │  Update Vlow   │     │      │   Update Vup    │
  │     └────────┬──────┘      │      └────────┬───────┘
  └──────────────┤             └───────────────┤
           ┌─────┴────────┐ S21          ┌──────┴────────┐  S17
           │ Estimate SOC by │            │ Estimate SOC by │
           │   current       │            │   current       │
           │  integration    │            │  integration    │
           └─────┬────────┘              └──────┬────────┘
              ┌──┴───┐                       ┌───┴───┐
              │  End  │                      │  End  │
              └──────┘                       └───────┘
```

Fig. 22

①

S22

NO ◇ Has set time elapsed?

YES

| | |
|---|---|
| Estimate SOC by current integration | S23 |

Acquire energy storage amount characteristics  S24

Calculate energy storage amount
Characteristics for voltage reference  S25

Estimate SOC  S26

End

Fig. 23

Start

Acquire feature value  S31

Estimate deterioration state  S32

End

Fig. 24

Fig. 25

Fig. 26

Number of cycles

Fig. 27

Number of cycles

Fig. 28

Fig. 29

Fig. 30

Fig. 31

## INTERNATIONAL SEARCH REPORT

| | International application No. |
|---|---|
| | PCT/JP2018/024811 |

**A. CLASSIFICATION OF SUBJECT MATTER**
Int.Cl. G01R31/36(2006.01)i, H01M10/42(2006.01)i, H01M10/48(2006.01)i, H02J7/00(2006.01)i

According to International Patent Classification (IPC) or to both national classification and IPC

**B. FIELDS SEARCHED**

Minimum documentation searched (classification system followed by classification symbols)
Int.Cl. G01R31/36, H01M10/42, H01M10/48, H02J7/00

Documentation searched other than minimum documentation to the extent that such documents are included in the fields searched
Published examined utility model applications of Japan     1922–1996
Published unexamined utility model applications of Japan   1971–2018
Registered utility model specifications of Japan           1996–2018
Published registered utility model applications of Japan   1994–2018

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2013-19709 A (TOYOTA MOTOR CORP.) 31 January 2013, paragraphs [0001], [0029]-[0090], fig. 2, 8-10 (Family: none) | 6,10,12,14<br>1-5,7-9,11,13 |
| Y<br>A | WO 2017/098686 A1 (SONY CORP.) 15 June 2017, paragraphs [0001], [0059], fig. 11 (Family: none) | 6,10,12,14<br>1-5,7-9,11,13 |

☒ Further documents are listed in the continuation of Box C.   ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 13 September 2018 (13.09.2018) | 25 September 2018 (25.09.2018) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

**INTERNATIONAL SEARCH REPORT**

International application No.

PCT/JP2018/024811

C (Continuation). DOCUMENTS CONSIDERED TO BE RELEVANT

| Category* | Citation of document, with indication, where appropriate, of the relevant passages | Relevant to claim No. |
|---|---|---|
| A | JP 2014-62829 A (GS YUASA INTERNATIONAL LTD.) 10 April 2014, paragraphs [0001], [0019]-[0067], fig. 1-9 & US 2014/0084939 A1, fig. 1-9, paragraphs [0002], [0019]-[0081] & EP 2711727 A2 & CN 103675697 A | 1-14 |
| A | JP 2013-140037 A (GS YUASA INTERNATIONAL LTD.) 18 July 2013, paragraphs [0001], [0028], [0030]-[0160], fig. 1-15 (Family: none) | 1-14 |
| A | JP 2015-60761 A (TOSHIBA CORP.) 30 March 2015, paragraphs [0001], [0009]-[0064], fig. 1-18 & US 2016/0195589 A1, fig. 1-18, paragraphs [0002], [0029]-[0084] & WO 2015/041091 A1 | 1-14 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

*   JP 2016085166 A

**Non-patent literature cited in the description**

*   *Journal of Power Sources,* 2013, vol. 229, 239-248